# EUROPEAN PATENT APPLICATION

(11) **EP 4 811 970 A1**
(43) Date of publication of application: **23.09.2026**
(21) Application number: 26164550.1
(22) Date of filing: 13.03.2026
(51) Int. Cl.: H10F 39/00, H04N 25/79, H04N 25/773

(54) **PHOTOELECTRIC CONVERSION APPARATUS AND PHOTOELECTRIC CONVERSION SYSTEM**

(30) Priority: 14.03.2025 JP 2025041567; 03.12.2025 JP 2025227123
(71) Applicant: Canon Kabushiki Kaisha, Tokyo 146-8501 (JP)
(72) Inventor: SHIMIZU, Shinichiro, Ohta-ku, Tokyo, 146-8501 (JP); IWATA, Koichiro, Ohta-ku, Tokyo, 146-8501 (JP); ITANO, Tetsuya, Ohta-ku, Tokyo, 146-8501 (JP); OTA, Yasuharu, Ohta-ku, Tokyo, 146-8501 (JP); OGURO, Yasuhiro, Ohta-ku, Tokyo, 146-8501 (JP); TSUCHIYA, Masayuki, Ohta-ku, Tokyo, 146-8501 (JP)
(74) Representative: TBK

(57) **Abstract**

Photoelectric conversion apparatus includes first and second substrates. The first substrate includes first unit circuits each having at least one photoelectric conversion element, the second substrate includes second unit circuits for processing signals output from the first substrate. The first substrate includes first region where first unit circuits of first group are arranged, and second region where first unit circuits of second group are arranged. The second substrate includes third region where second unit circuits of third group are arranged, and fourth region where second unit circuits of fourth group are arranged. The third and fourth regions are arranged to be shifted from the first and second regions, respectively, so that the third and fourth regions are separated from each other, and distance between the third and fourth regions is smaller than array pitch of the first unit circuits in the first substrate.

## Description

### TECHNICAL FIELD

The present disclosure relates to a photoelectric conversion apparatus and a photoelectric conversion system.

### BACKGROUND

When the size of a photoelectric conversion apparatus exceeds the maximum size that can be exposed by an exposure apparatus for a photolithography step, a method called divisional exposure can be used. Divisional exposure is a method of dividing the exposure target region of a substrate into two or more partial regions, and performing exposure for each partial region. Japanese Patent Laid-Open No. 2005-223707 describes a solid-state image capturing element which is manufactured by divisional exposure. The solid-state image capturing element includes a pattern layer formed by divisional exposure on a substrate provided with a plurality of photoelectric conversion regions. A solid-state image capturing apparatus mounted with the solid-state image capturing element includes a lens for allowing light to enter a plurality of photoelectric conversion regions of the solid-state image capturing element, and the optical axis center of the lens is approximately set at the connection position of divisional exposure in the pattern layer.

When a plurality of partial regions of an exposure target region are exposed by divisional exposure, a certain amount of connection error can occur in the connection portion. For example, when the first partial region and the second partial region are respectively exposed by divisional exposure, if the first partial region is exposed while being shifted to the side of the second partial region, the requirement of the minimum space between the first partial region and the second partial region may not be met. This leads to a decrease in yield.

### SUMMARY

The present disclosure provides a photoelectric conversion apparatus with an arrangement advantageous for manufacturing by divisional exposure.

The present disclosure in its first aspect provides a photoelectric conversion apparatus as specified in claim 1. Optional features are specified in claims 1 to 17.

The present disclosure in its second aspect provides a photoelectric conversion system as specified in claim 18.

Features of the present disclosure will become apparent from the following description of embodiments with reference to the attached drawings. The following description of embodiments is described by way of example.

### BRIEF DESCRIPTION OF THE DRAWINGS

The accompanying drawings, which are incorporated in and constitute a part of the specification, illustrate embodiments of the present disclosure, and together with the description, serve to explain the principles of the embodiments.
Fig. 1 is a view showing an example of the arrangement of a photoelectric conversion apparatus according to an embodiment;
Fig. 2 is a view showing an example of the arrangement of the first substrate;
Fig. 3 is a view showing an example of the arrangement of the second substrate;
Fig. 4 is a view showing an example of the arrangement of a photoelectric conversion element and a pixel circuit;
Figs. 5A to 5C are views for explaining a photon detection operation;
Fig. 6 is a view showing an example of the arrangement of a photoelectric conversion apparatus according to the first embodiment;
Fig. 7 is a view showing the example of the arrangement of the photoelectric conversion apparatus according to the first embodiment;
Fig. 8 is a view showing the example of the arrangement of the photoelectric conversion apparatus according to the first embodiment;
Fig. 9 is a view showing an example of the arrangement of a photoelectric conversion apparatus according to the second embodiment;
Fig. 10 is a view showing the example of the arrangement of the photoelectric conversion apparatus according to the second embodiment;
Fig. 11 is a view showing the example of the arrangement of the photoelectric conversion apparatus according to the second embodiment;
Fig. 12 is a view showing an example of the arrangement of a photoelectric conversion apparatus according to the third embodiment;
Fig. 13 is a view showing the example of the arrangement of the photoelectric conversion apparatus according to the third embodiment;
Fig. 14 is a view showing the example of the arrangement of the photoelectric conversion apparatus according to the third embodiment;
Fig. 15 is a view showing an example of the arrangement of a photoelectric conversion apparatus according to the fourth embodiment;
Fig. 16 is a view showing the example of the arrangement of the photoelectric conversion apparatus according to the fourth embodiment;
Fig. 17 is a view showing the example of the arrangement of the photoelectric conversion apparatus according to the fourth embodiment;
Fig. 18 is a view showing an example of the arrangement of a photoelectric conversion apparatus according to the fifth embodiment;
Fig. 19 is a view showing the example of the arrangement of the photoelectric conversion apparatus according to the fifth embodiment;
Fig. 20 is a view showing an example of the arrangement of a photoelectric conversion apparatus according to the sixth embodiment;
Fig. 21 is a view showing the example of the arrangement of the photoelectric conversion apparatus according to the sixth embodiment;
Fig. 22 is a view showing the example of the arrangement of the photoelectric conversion apparatus according to the sixth embodiment;
Fig. 23 is a view showing an example of the arrangement of a photoelectric conversion apparatus according to the seventh embodiment;
Fig. 24 is a view showing an example of the arrangement of a photoelectric conversion apparatus according to the eighth embodiment;
Fig. 25 is a view showing the example of the arrangement of the photoelectric conversion apparatus according to the eighth embodiment;
Fig. 26 is a view showing an example of the arrangement of a photoelectric conversion apparatus according to the ninth embodiment;
Fig. 27 is a view showing the example of the arrangement of the photoelectric conversion apparatus according to the ninth embodiment;
Fig. 28 is a view showing an example of the arrangement of a photoelectric conversion apparatus according to the tenth embodiment;
Fig. 29 is a view showing the example of the arrangement of the photoelectric conversion apparatus according to the tenth embodiment;
Fig. 30 is a view showing the example of the arrangement of the photoelectric conversion apparatus according to the tenth embodiment;
Fig. 31 is a view illustrating the maximum space width;
Fig. 32 is a view showing an example of the arrangement of a photoelectric conversion apparatus according to the eleventh embodiment;
Fig. 33 is a view showing an example of the arrangement of a photoelectric conversion apparatus according to the twelfth embodiment;
Fig. 34 is a functional block diagram of a photoelectric conversion system according to the first application example;
Figs. 35A and 35B are functional block diagrams of a photoelectric conversion system according to the second application example;
Fig. 36 is a functional block diagram of a photoelectric conversion system according to the third application example;
Fig. 37 is a functional block diagram of a photoelectric conversion system according to the fourth application example;
Figs. 38A and 38B are views each showing a photoelectric conversion system according to the fifth application example;
Figs. 39A and 39B are views showing a photoelectric conversion system according to the sixth application example; and
Fig. 40 is a functional block diagram of a photoelectric conversion system according to the seventh application example.

### DESCRIPTION OF THE EMBODIMENTS

Hereinafter, embodiments will be described in detail with reference to the attached drawings. Note, the following embodiments are not intended to limit the scope of the claims. Multiple features are described in the embodiments, but it is not the case that all such features are required, and multiple such features may be combined as appropriate. Furthermore, in the attached drawings, the same reference numerals are given to the same or similar configurations, and redundant description thereof is omitted.

In this specification, conductivity types of semiconductor regions different from each other are distinguished as the first conductivity type and the second conductivity type. The first conductivity type is a conductivity type which uses charge with the first polarity as a majority carrier, and the second conductivity type is a conductivity type which uses charge with the second polarity as a majority carrier. In a case where the first polarity is positive, the charge with the first polarity is a hole, the first conductivity type is the p type, the second polarity is negative, the charge with the second polarity is an electron, and the second conductivity type is the n type. To the contrary, in a case where the first polarity is negative, the charge with the first polarity is an electron, the first conductivity type is the n type, the second polarity is positive, the charge with the second polarity is a hole, and the second conductivity type is the p type.

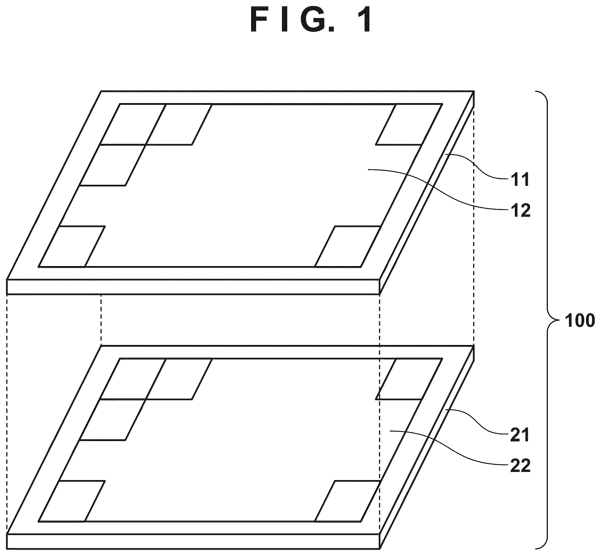

Fig. 1 schematically shows an example of the arrangement of a photoelectric conversion apparatus 100 according to an embodiment of the present disclosure. The photoelectric conversion apparatus 100 can have, for example, a structure in which a first substrate 11 and a second substrate 21 are stacked. The first substrate 11 can include, for example, a photoelectric conversion element array 12 including a plurality of photoelectric conversion elements. The second substrate 21 can include at least a part of a processing circuit 22 that processes signals output from the plurality of photoelectric conversion elements. A part of the processing circuit 22 may be arranged in the first substrate 11. The photoelectric conversion apparatus 100 may include one or more other substrates such as the third substrate.

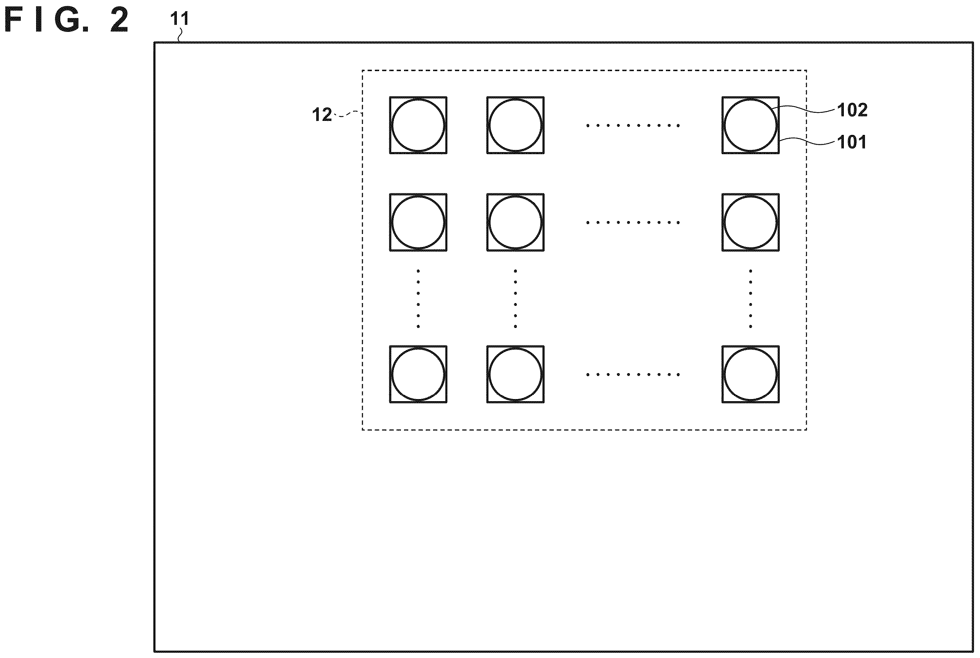

Fig. 2 schematically shows an example of the arrangement of the first substrate 11. The photoelectric conversion element array 12 of the first substrate 11 can include a plurality of photoelectric conversion elements 102 arranged to form a plurality of rows and a plurality of columns. Each photoelectric conversion element 102 constitutes a part of a pixel 101. The photoelectric conversion apparatus 100 will exemplarily be described below as an image capturing apparatus. However, the photoelectric conversion apparatus 100 may be formed as another apparatus. For example, the photoelectric conversion apparatus 100 can be formed as a distance measurement apparatus (for example, a focus detection apparatus or a distance measurement apparatus using TOF (Time Of Flight)) or a photometric apparatus (an apparatus for, for example, measuring an incident light amount). Note that a plurality of pixels 101 may linearly be arranged. In this case, the photoelectric conversion apparatus 100 can form a line sensor.

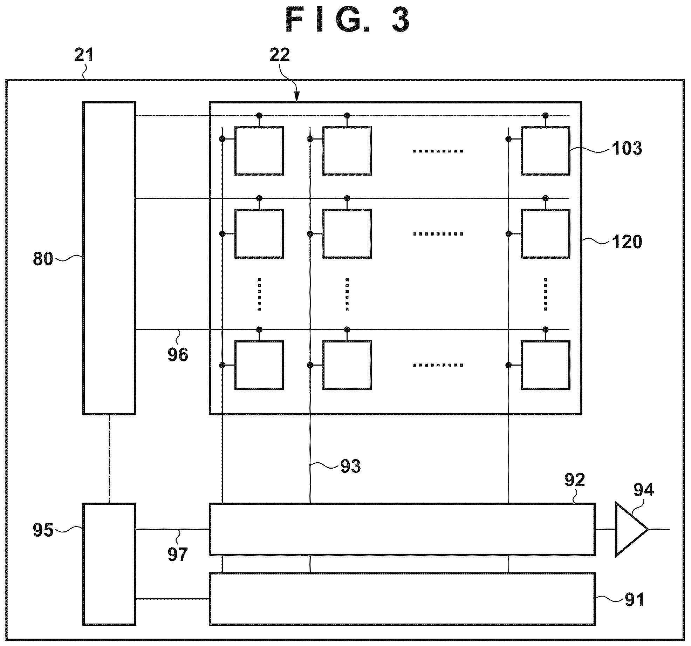

Fig. 3 schematically shows the arrangement of the processing circuit 22 of the second substrate 21. The processing circuit 22 can include, for example, a pixel circuit array 120 including a plurality of pixel circuits 103, a readout circuit 92, a control unit 95, a horizontal scanning circuit 91, a plurality of signal lines 93, a vertical scanning circuit 80, and an output unit 94. Each pixel circuit 103 constitutes the pixel 101 together with the corresponding photoelectric conversion element 102, and processes a signal output from the photoelectric conversion element 102. One pixel circuit 103 may be provided for one photoelectric conversion element 102, or one pixel circuit 103 may be provided for two or more photoelectric conversion elements 102. In an example, one photoelectric conversion element 102 and one pixel circuit 103 can electrically be connected by a connection portion. The pixel circuit 103 can include, for example, a counter and a memory. The memory can hold a count value obtained by counting by the counter. The photoelectric conversion element array 12 and the pixel circuit array 120 constitute a pixel array.

For example, the vertical scanning circuit 80 can sequentially select a plurality of rows of the photoelectric conversion element array 12 in accordance with a control signal supplied from the control unit 95. The vertical scanning circuit 80 can include, for example, at least one of a shift register and an address decoder. The readout circuit 92 reads out signals output, via the plurality of signal lines 93, from the pixel circuits 103 corresponding to the pixels 101 of the row selected by the vertical scanning circuit 80. For example, the horizontal scanning circuit 91 supplies to the output unit 94, in a predetermined order, the signals for one row read out by the readout circuit 92.

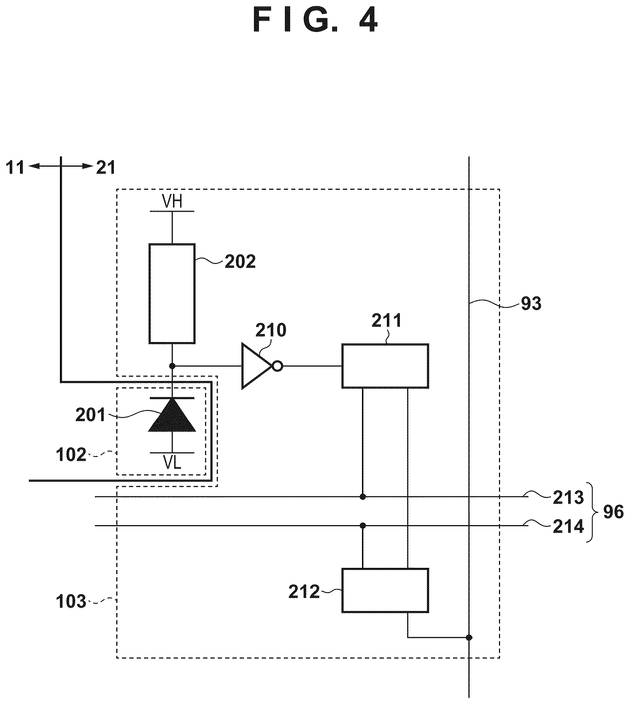

Fig. 4 shows an example of the arrangement of the photoelectric conversion element 102 and the pixel circuit 103. In the example shown in Fig. 4, one pixel circuit 103 is assigned to one photoelectric conversion element 102. The photoelectric conversion element 102 includes an avalanche photodiode (APD) 201. At least one of a plurality of components of the pixel circuit 103 may be arranged on the first substrate 11. Alternatively, all the plurality of components of the pixel circuit 103 may be arranged on the first substrate 11.

A first voltage VH can be applied to the cathode of the APD 201. A second voltage VL is applied to the anode of the APD 201, and the first voltage VH has a potential higher than the potential of the second voltage VL. A potential difference between the first voltage VH and the second voltage VL is applied across the APD 201 (between the anode and cathode of the APD 201). This potential difference is a reverse bias voltage that causes the APD 201 to perform an avalanche multiplication operation. Charges generated by photons entering the APD 201 cause avalanche multiplication, thereby generating an avalanche current. A mode of applying a voltage higher than the breakdown voltage of the APD 201 between the anode and cathode of the APD 201 is called a Geiger mode. A mode of applying a voltage around or lower than the breakdown voltage between the anode and cathode of the APD 201 is called a linear mode. An APD operating in the Geiger mode is called an SPAD. In an example, the first voltage VH is 1 V, and the second voltage VL is - 30 V.

The pixel circuit 103 can include a quenching element 202 connected between the cathode of the APD 201 and a terminal supplied with the first voltage VH. The quenching element 202 may be understood as an element that supplies the first voltage VH to the cathode of the APD 201. The quenching element 202 has a function of converting the change of the avalanche current generated in the APD 201 into a voltage signal. The quenching element 202 functions as a load circuit (quenching circuit) at the time of signal multiplication by avalanche multiplication, and serves to suppress avalanche multiplication by suppressing the voltage applied to the APD 201. This is known as a quenching operation.

The pixel circuit 103 can additionally include, for example, at least one of a waveform shaping circuit 210, a counter circuit 211, and a selection circuit 212. The waveform shaping circuit 210 can output a pulse signal by shaping the potential change of the cathode of the APD 201 at the time of detection of a photon. The waveform shaping circuit 210 can include, for example, an inverter circuit. In the example shown in Fig. 4, the waveform shaping circuit 210 is formed by one inverter, but the waveform shaping circuit 210 may be formed by series-connecting a plurality of inverters or by another circuit having the waveform shaping effect.

The counter circuit 211 can be configured to count a pulse signal output from the waveform shaping circuit 210 and hold a count value obtained by counting. When a first control pulse of an active level is supplied from the vertical scanning circuit 80 via a driving line 213, the signal held in the counter circuit 211 can be reset. When a second control pulse of an active level is supplied from the vertical scanning circuit80 via a driving line 214, the selection circuit 212 can electrically connect the counter circuit 211 and the signal line 93. The selection circuit 212 can include, for example, a buffer circuit.

In this example, the counter circuit 211 is provided. However, the photoelectric conversion apparatus 100 may be configured to acquire a pulse detection timing by providing a Time-to-Digital Converter (to be referred to as a TDC hereinafter), instead of the counter circuit 211. In this case, the generation timing of the pulse signal output from the waveform shaping circuit 210 can be converted into a digital signal by the TDC. A reference pulse (reference signal) can be supplied from the vertical scanning circuit80 to the TDC via a driving line to measure the timing of the pulse signal. With reference to the reference pulse, the TDC can generate a digital signal corresponding to the generation timing of the pulse signal output from the waveform shaping circuit 210.

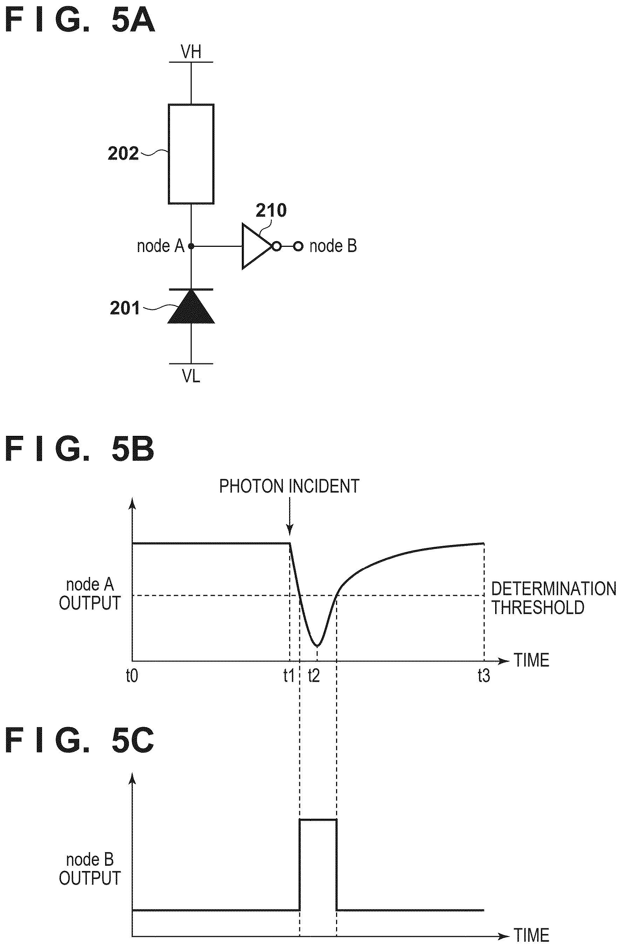

Figs. 5A to 5C are views for explaining a photon detection operation by the photoelectric conversion apparatus 100. Fig. 5A is a view showing an excerpt of the APD 201, the quenching element 202, and the waveform shaping circuit 210 from Fig. 4. The input side of the waveform shaping circuit 210 is a node A and the output side of the waveform shaping circuit 210 is a node B. Fig. 5B shows the waveform at the node A of Fig. 5A and Fig. 5C shows the waveform at the node B of Fig. 5A. From time t0 to time t1, a potential difference between VH and VL is applied to the APD 201. When a photon enters at time t1, avalanche multiplication occurs in the APD 201. This causes an avalanche multiplication current to flow into the quenching element 202, and the voltage (potential) of the node A drops. When the voltage drop amount increases and the potential difference applied to the APD 201 decreases, the avalanche multiplication of the APD 201 stops. After that, a current compensating for the voltage drop from the voltage VL flows into the node A, and the node A settles at the original potential level at time t3. At this time, a portion at which the output waveform exceeds a given threshold at the node A is waveform-shaped by the waveform shaping circuit 210 and a pulse signal appears at the node B.

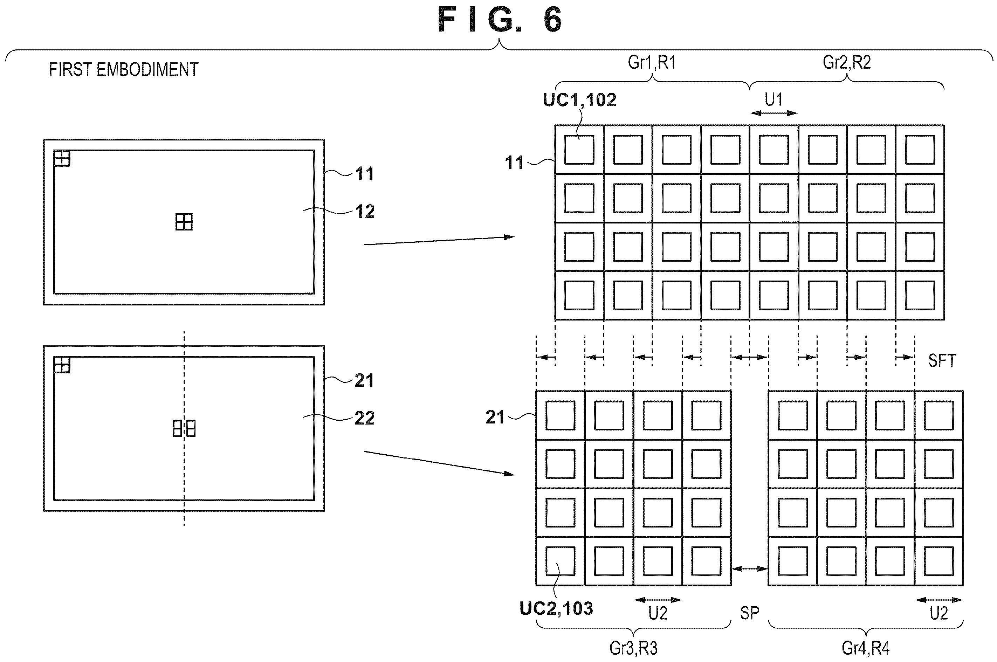

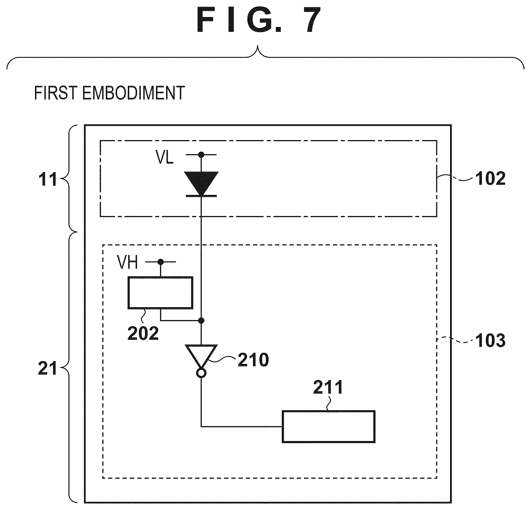

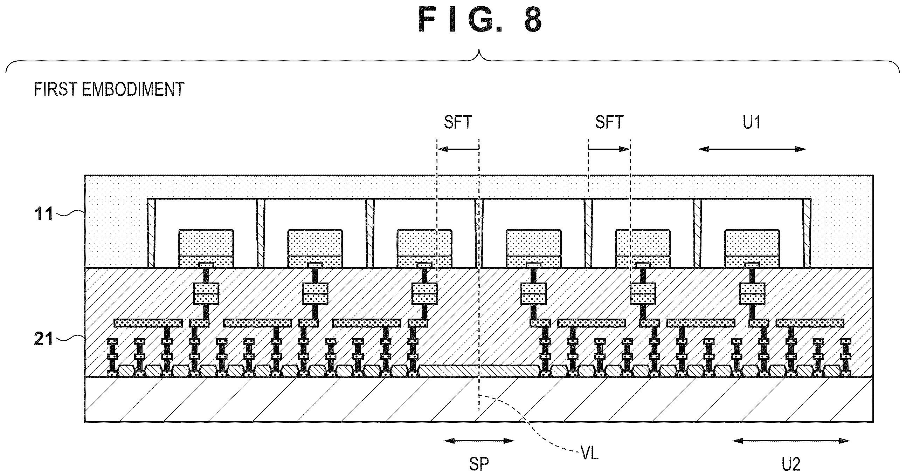

With reference to Figs. 6 to 8, a photoelectric conversion apparatus 100 according to the first embodiment will be described below. Fig. 6 is a view for explaining a first substrate 11 and a second substrate 21 constituting the photoelectric conversion apparatus 100. Fig. 7 is a view showing the arrangement of a pixel 101. Fig. 8 is a schematic sectional view showing the arrangement of the photoelectric conversion apparatus 100.

In the first embodiment, the first substrate 11 is a substrate formed through a lithography step using one-shot exposure, and the second substrate 21 is a substrate formed through a lithography step using divisional exposure. One-shot exposure means that the entire exposure target region is exposed in a single exposure process. When using a stepper, the single exposure process is a process of irradiating the entire exposure target region with exposure light at once. When using a scanner, the single exposure process is a process of continuously scanning and exposing the exposure target region. In Fig. 6, a dotted line in the second substrate 21 on the left side schematically indicates that a third region R3 and a fourth region R4 of the second substrate are each subjected to divisional exposure.

The first substrate 11 can include a plurality of first unit circuits UC1, and each first unit circuit UC1 can include at least one photoelectric conversion element 102. The second substrate 21 can include a plurality of second unit circuits UC2 configured to process signals output from the first substrate 11. The first substrate 11 can include a first region R1 where the first unit circuits UC1 of a first group Gr1 out of the plurality of first unit circuits UC1 are arranged, and a second region R2 where the first unit circuits UC1 of a second group Gr2 out of the plurality of first unit circuits UC1 are arranged. The second substrate 21 can include the third region R3 where the second unit circuits UC2 of a third group Gr3 out of the plurality of second unit circuits UC2 are arranged, and the fourth region R4 where the second unit circuits UC2 of a fourth group Gr4 out of the plurality of second unit circuits UC2 are arranged.

As schematically shown in Figs. 6 and 8, the third region R3 and the fourth region R4 can be arranged to be shifted from the first region R1 and the second region R2, respectively, so that the third region R3 and the fourth region R4 are separated from each other. In the example shown in Figs. 6 and 8, the third region R3 is shifted from the first region R1 by a shift amount SFT, and the fourth region R4 is shifted from the second region R2 by the shift amount SFT. These shift amounts are equal to each other. However, the shift amount of the third region R3 from the first region R1 and the shift amount of the fourth region R4 from the second region R2 may be different from each other. In a planar view, the first region R1 and the second region R2 may be line-symmetric with respect to a virtual line VL, and the third region R3 and the fourth region R4 may be line-symmetric with respect to the virtual line VL. This arrangement is advantageous for uniformizing the characteristics related to signal readout from the plurality of pixels 101 included in the photoelectric conversion apparatus 100. Note that the planar view is an orthogonal projection onto the main surface of the first substrate 11.

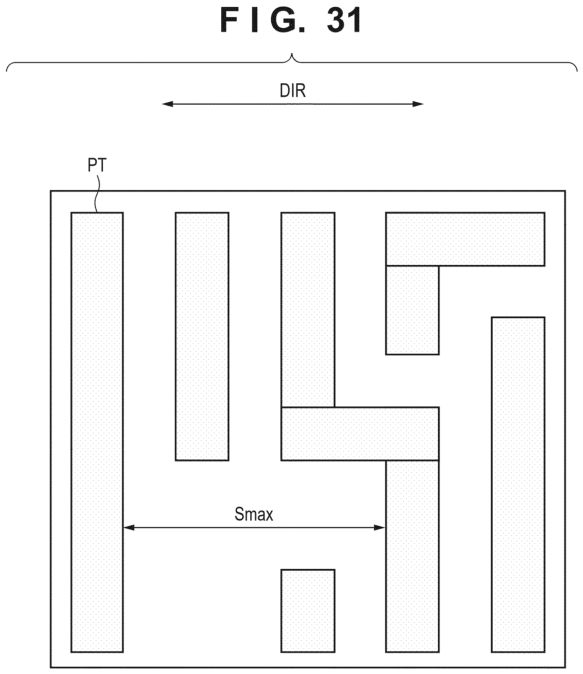

In the example shown in Figs. 6 and 8, the third region R3 and the fourth region R4 are separated by a separation amount SP, that is, the distance between the third region R3 and the fourth region R4 is the distance SP. For example, the distance SP is preferably larger than the maximum space width in the second unit circuit UC2 arranged in the third region R3, and the maximum space width in the second unit circuit UC2 arranged in the fourth region R4. The maximum space width can be the maximum space width in a direction DIR separating the third region R3 and the fourth region R4, as illustrated as Smax in Fig. 31. Satisfying this condition can allow for an alignment error during divisional exposure for forming the second substrate 21, which causes deviations of the circuit patterns formed in the third region R3 and/or the fourth region R4. That is, even if the shift of the circuit pattern is deviated due to an alignment error, a defect (for example, a minimum spacing error) in the connection portion between the third region R3 and the fourth region R4 can be prevented from occurring.

From one viewpoint, in the direction separating the third region R3 and the fourth region R4, an array pitch U1 of the first unit circuit UC1 in the first substrate 11 is equal to an array pitch U2 of the second unit circuit UC2 of the third group Gr3 in the second substrate 21. Furthermore, in the direction separating the third region R3 and the fourth region R4, the array pitch U1 of the first unit circuit UC1 in the first substrate 11 is equal to the array pitch U2 of the second unit circuit UC2 of the fourth group Gr4 in the second substrate 21. In this arrangement, the distance SP between the third region R3 and the fourth region R4 is preferably smaller than the array pitch U1 of the plurality of first unit circuits UC1 in the first substrate 11. This is advantageous for preventing wasted space and miniaturizing the photoelectric conversion apparatus 100.

From another viewpoint, in the direction separating the third region R3 and the fourth region R4, the array pitch U2 of the second unit circuit UC2 of the third group Gr3 in the second substrate 21 and the array pitch U2 of the second unit circuit UC2 of the fourth group Gr4 in the second substrate 21 are equal to each other. In this arrangement, the distance SP between the third region R3 and the fourth region R4 is preferably smaller than the array pitch U2 of the second unit circuit UC2 of the third group Gr3 (and the fourth group Gr4) in the second substrate 21. This is advantageous for preventing wasted space and miniaturizing the photoelectric conversion apparatus 100.

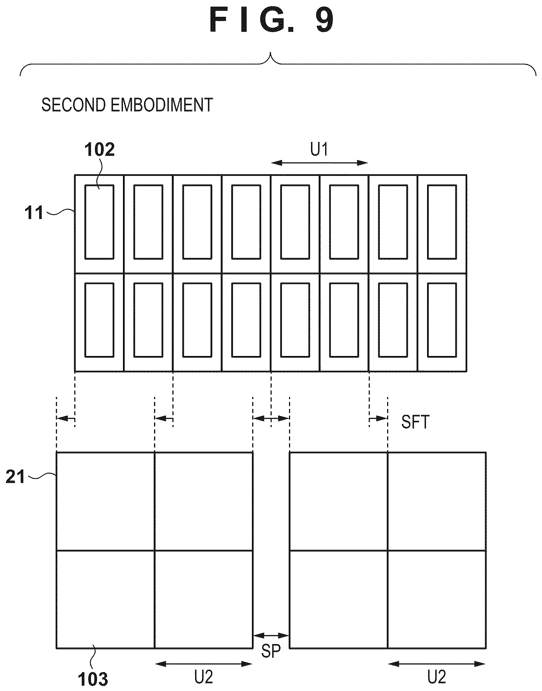

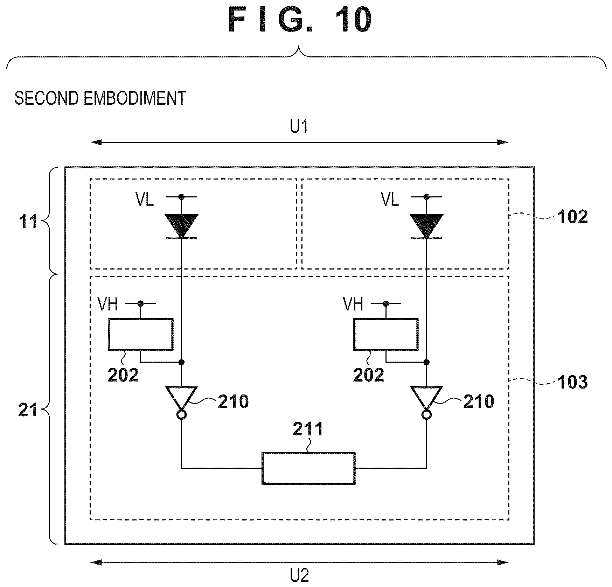

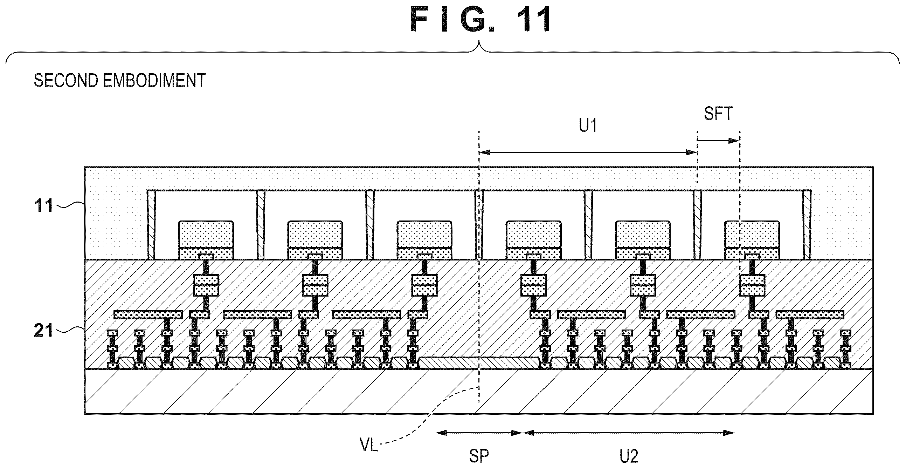

With reference to Figs. 9 to 11, a photoelectric conversion apparatus 100 according to the second embodiment will be described. Matters not mentioned regarding the second embodiment can follow the description of the first embodiment. Fig. 9 is a view for explaining a first substrate 11 and a second substrate 21 constituting the photoelectric conversion apparatus 100. Fig. 10 is a view showing the arrangement of a pixel 101. Fig. 11 is a schematic sectional view showing the arrangement of the photoelectric conversion apparatus 100.

In the second embodiment, as in the first embodiment, the first substrate 11 can include a plurality of first unit circuits UC1, and each first unit circuit UC1 can include two photoelectric conversion elements 102. On the other hand, the second substrate 21 can include a plurality of second unit circuits UC2, and each second unit circuit UC2 can include a pixel circuit 103 assigned to two pixels 101. Each pixel circuit 103 can be configured to share one counter circuit 211 between two pixels 101. Therefore, in the second embodiment, in the direction separating a third region R3 and a fourth region R4, an array pitch U2 of the second unit circuit UC2 of a third group Gr3 in the second substrate 21 is larger than an array pitch U1 of the first unit circuit UC1 in the first substrate 11. Furthermore, in the second embodiment, in the direction separating the third region R3 and the fourth region R4, the array pitch U2 of the second unit circuit UC2 of a fourth group Gr4 in the second substrate 21 is larger than the array pitch U1 of the first unit circuit UC1 in the first substrate 11. More specifically, in the direction separating the third region R3 and the fourth region R4, the array pitch U2 of the second unit circuit UC2 of the third group Gr3 in the second substrate 21 is twice the array pitch U1 of the first unit circuit UC1 in the first substrate 11. Furthermore, in the direction separating the third region R3 and the fourth region R4, the array pitch U2 of the second unit circuit UC2 of the fourth group Gr4 in the second substrate 21 is twice the array pitch U1 of the first unit circuit UC1 in the first substrate 11.

From one viewpoint, a distance SP between the third region R3 and the fourth region R4 is preferably smaller than the array pitch U1 of the plurality of first unit circuits UC1 in the first substrate 11. From another viewpoint, the distance SP between the third region R3 and the fourth region R4 is preferably smaller than the array pitch U2 of the second unit circuit UC2 of the third group Gr3 (and the fourth group Gr4) in the second substrate 21. This is advantageous for preventing wasted space and miniaturizing the photoelectric conversion apparatus 100.

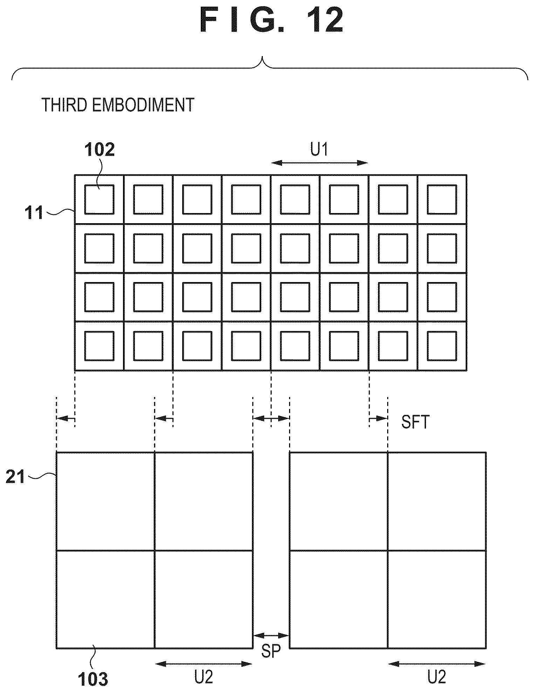

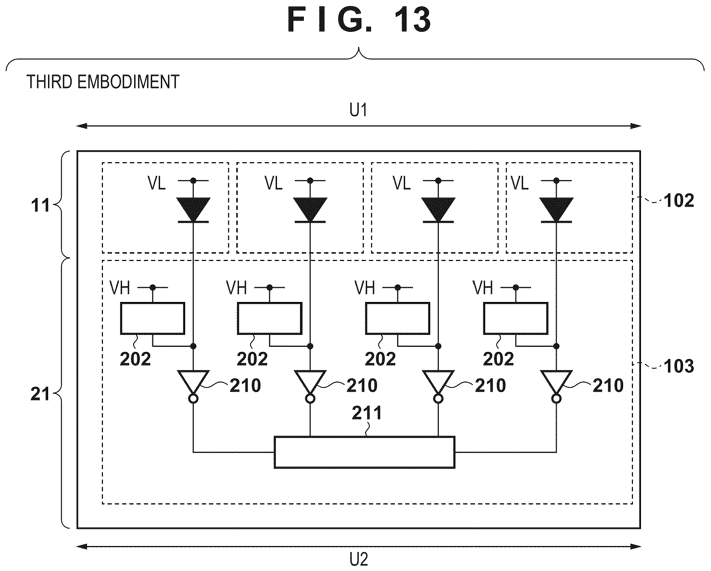

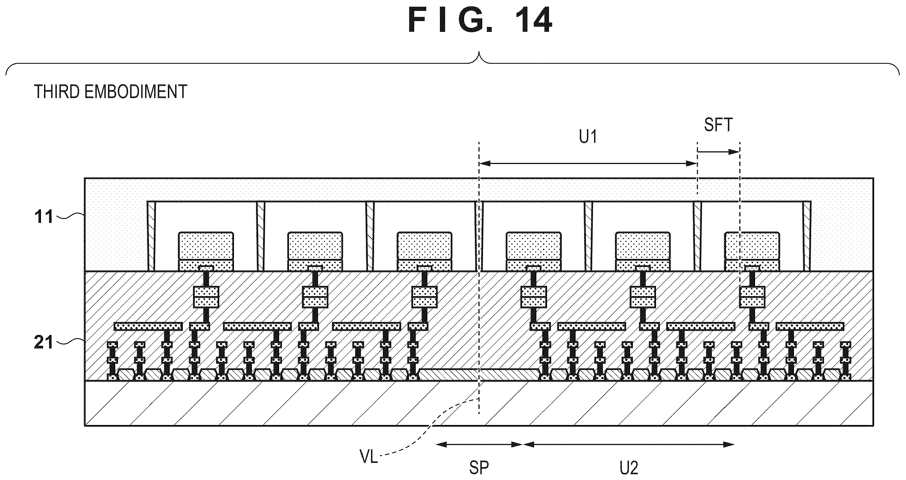

With reference to Figs. 12 to 14, a photoelectric conversion apparatus 100 according to the third embodiment will be described. Matters not mentioned regarding the third embodiment can follow the description of the first or second embodiment. Fig. 12 is a view for explaining a first substrate 11 and a second substrate 21 constituting the photoelectric conversion apparatus 100. Fig. 13 is a view showing the arrangement of a pixel 101. Fig. 14 is a schematic sectional view showing the arrangement of the photoelectric conversion apparatus 100.

In the third embodiment, the first substrate 11 can include a plurality of first unit circuits UC1, and each first unit circuit UC1 can include four photoelectric conversion elements 102. The second substrate 21 can include a plurality of second unit circuits UC2, and each second unit circuit UC2 can include a pixel circuit 103 assigned to four pixels 101 forming two rows and two columns. Each pixel circuit 103 can be configured to share one counter circuit 211 between four pixels 101. Therefore, in the third embodiment, in the direction separating a third region R3 and a fourth region R4, an array pitch U2 of the second unit circuit UC2 of a third group Gr3 in the second substrate 21 is larger than an array pitch U1 of the first unit circuit UC1 in the first substrate 11. Furthermore, in the third embodiment, in the direction separating the third region R3 and the fourth region R4, the array pitch U2 of the second unit circuit UC2 of a fourth group Gr4 in the second substrate 21 is larger than the array pitch U1 of the first unit circuit UC1 in the first substrate 11. More specifically, in the direction separating the third region R3 and the fourth region R4, the array pitch U2 of the second unit circuit UC2 of the third group Gr3 in the second substrate 21 is twice the array pitch U1 of the first unit circuit UC1 in the first substrate 11. Furthermore, in the direction separating the third region R3 and the fourth region R4, the array pitch U2 of the second unit circuit UC2 of the fourth group Gr4 in the second substrate 21 is twice the array pitch U1 of the first unit circuit UC1 in the first substrate 11.

From one viewpoint, a distance SP between the third region R3 and the fourth region R4 is preferably smaller than the array pitch U1 of the plurality of first unit circuits UC1 in the first substrate 11. From another viewpoint, the distance SP between the third region R3 and the fourth region R4 is preferably smaller than the array pitch U2 of the second unit circuit UC2 of the third group Gr3 (and the fourth group Gr4) in the second substrate 21. This is advantageous for preventing wasted space and miniaturizing the photoelectric conversion apparatus 100.

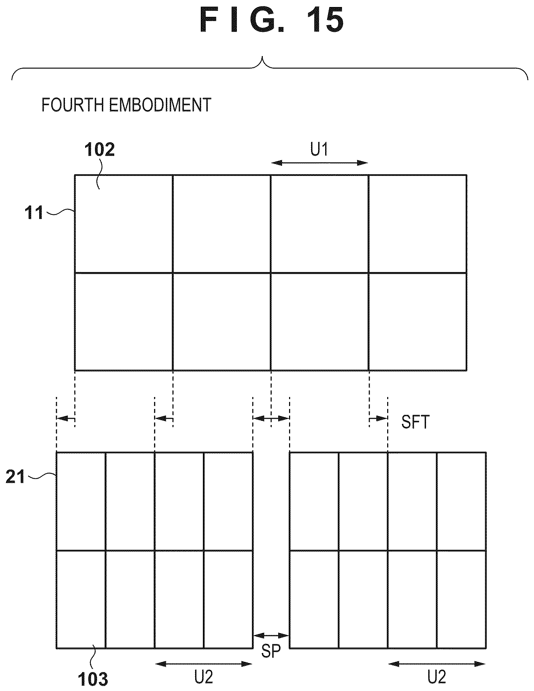

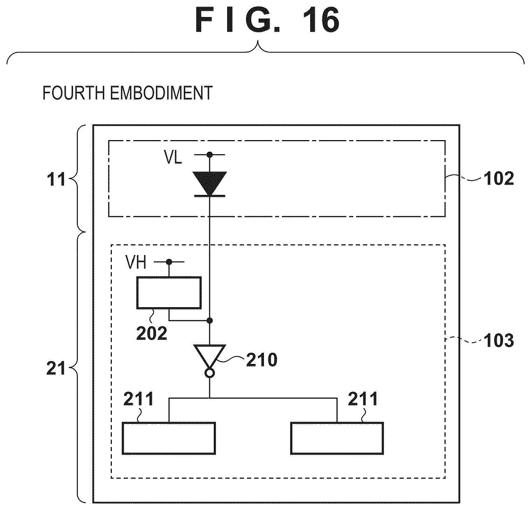

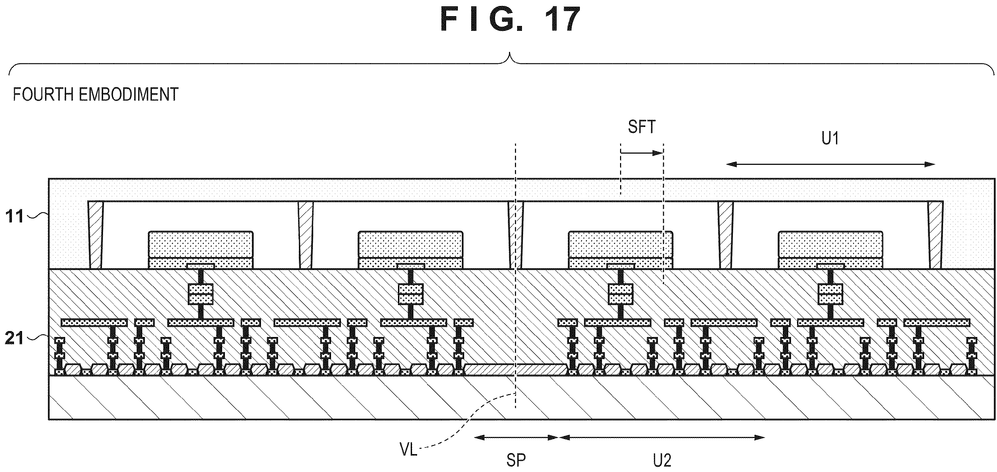

With reference to Figs. 15 to 17, a photoelectric conversion apparatus 100 according to the fourth embodiment will be described. Matters not mentioned regarding the fourth embodiment can follow the description of the first to third embodiments. Fig. 15 is a view for explaining a first substrate 11 and a second substrate 21 constituting the photoelectric conversion apparatus 100. Fig. 16 is a view showing the arrangement of a pixel 101. Fig. 17 is a schematic sectional view showing the arrangement of the photoelectric conversion apparatus 100.

In the fourth embodiment, the first substrate 11 can include a plurality of first unit circuits UC1, and each first unit circuit UC1 can include at least one photoelectric conversion element 102. The second substrate 21 can include a plurality of second unit circuits UC2, and each second unit circuit UC2 can include a pixel circuit 103 assigned to four pixels 101 forming two rows and two columns. Each pixel circuit 103 can be configured to provide two counter circuits 211 with respect to one pixel 101. In the fourth embodiment, in the direction separating a third region R3 and a fourth region R4, an array pitch U1 of the first unit circuit UC1 in the first substrate 11 is equal to an array pitch U2 of the second unit circuit UC2 in a third group Gr3 in the second substrate 21.

From one viewpoint, a distance SP between the third region R3 and the fourth region R4 is preferably smaller than the array pitch U1 of the plurality of first unit circuits UC1 in the first substrate 11. From another viewpoint, the distance SP between the third region R3 and the fourth region R4 is preferably smaller than the array pitch U2 of the second unit circuit UC2 of the third group Gr3 (and the fourth group Gr4) in the second substrate 21. This is advantageous for preventing wasted space and miniaturizing the photoelectric conversion apparatus 100.

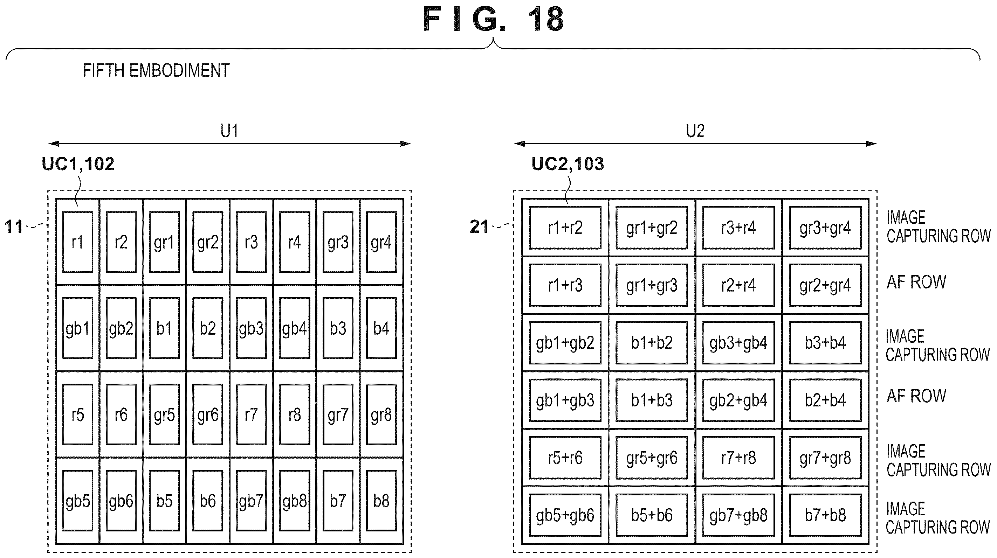

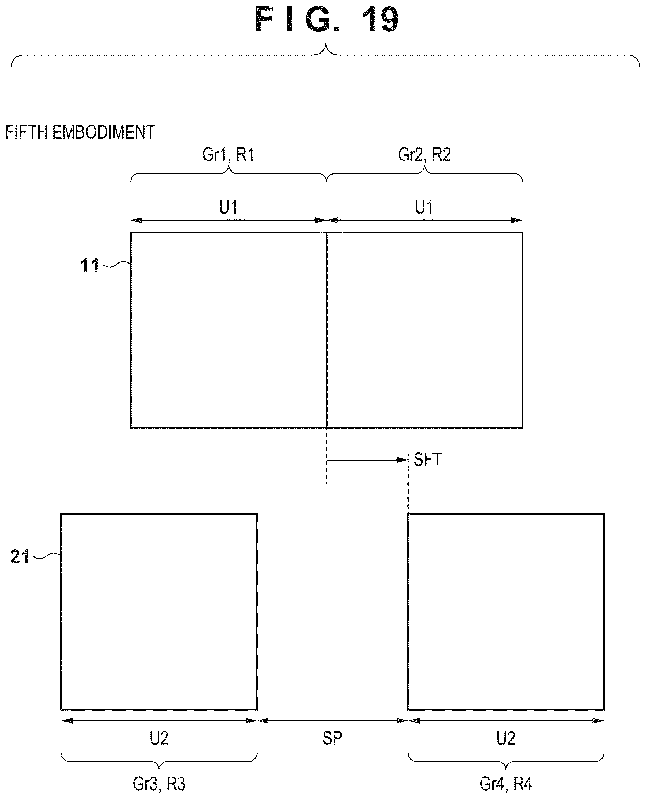

With reference to Figs. 18 and 19, a photoelectric conversion apparatus 100 according to the fifth embodiment will be described. Matters not mentioned regarding the fifth embodiment can follow the description of the first to fourth embodiments. Fig. 18 is a view for explaining a first substrate 11 and a second substrate 21 constituting the photoelectric conversion apparatus 100. Fig. 19 is a view showing the positional relationship between a plurality of first unit circuits UC1 in the first substrate 11 and a plurality of second unit circuits UC2 in the second substrate 21. As for the positional relationship between the plurality of first unit circuits UC1 in the first substrate 11 and the plurality of second unit circuits UC2 in the second substrate 21, the arrangement in a section of the photoelectric conversion apparatus 100 according to the fifth embodiment is similar to that shown in Fig. 6.

In the fifth embodiment, the first substrate 11 can include the plurality of first unit circuits UC1, and each first unit circuit UC1 can include 32 photoelectric conversion elements 102. The second substrate 21 can include 24 second unit circuits UC2 configured to process signals output from the first substrate 11. In the first substrate 11, the photoelectric conversion elements 102 arranged to form four rows and eight columns constitute one unit circuit UC1. In the second substrate 21, the photoelectric conversion elements 102 arranged to form six rows and four columns constitute one unit circuit UC2.

In the first substrate 11 shown in Figs. 18 and 19, pixels indicated in a form of rx (for example, r1 and r2) are R (red) pixels forming a pair for phase difference detection by a pupil division method. Similarly, pixels indicated in a form of grx (for example, gr1 and gr2) are G (green) pixels forming a pair for phase difference detection by the pupil division method, and arranged in the same row as the R pixels. Similarly, pixels indicated in a form of bx (for example, b1 and b2) are B (blue) pixels forming a pair for phase difference detection by the pupil division method. Similarly, pixels indicated in a form of gbx (for example, gb1 and gb2) are G (green) pixels forming a pair for phase difference detection by the pupil division method, and arranged in the same row as the B pixels.

In the second substrate 21 shown in Figs. 18 and 19, a pixel circuit 103 indicated in a form of A + B is a circuit configured to process signals of the A pixel and the B pixel. In the first row and the first column, A is r1 and B is r2. The pixel circuit 103 in the row indicated as "image capturing row" is a processing circuit for image capturing, and the pixel circuit 103 in the row indicated as "AF row" is a processing circuit for AF.

In the fifth embodiment, in the direction separating a third region R3 and a fourth region R4, an array pitch U1 of the first unit circuit UC1 in the first substrate 11 is equal to an array pitch U2 of the second unit circuit UC2 of a third group Gr3 in the second substrate 21. Furthermore, in the direction separating the third region R3 and the fourth region R4, the array pitch U1 of the first unit circuit UC1 in the first substrate 11 is equal to the array pitch U2 of the second unit circuit UC2 of a fourth group Gr4 in the second substrate 21. In this arrangement, a distance SP between the third region R3 and the fourth region R4 is preferably smaller than the array pitch U1 of the plurality of first unit circuits UC1 in the first substrate 11. This is advantageous for preventing wasted space and miniaturizing the photoelectric conversion apparatus 100.

From another viewpoint, in the direction separating the third region R3 and the fourth region R4, the array pitch U2 of the second unit circuit UC2 of the third group Gr3 in the second substrate 21 is equal to the array pitch U2 of the second unit circuit UC2 of the fourth group Gr4 in the second substrate 21. In this arrangement, the distance SP between the third region R3 and the fourth region R4 is preferably smaller than the array pitch U2 of the second unit circuit UC2 in the third group Gr3 (and the fourth group Gr4) in the second substrate 21. This is advantageous for preventing wasted space and miniaturizing the photoelectric conversion apparatus 100.

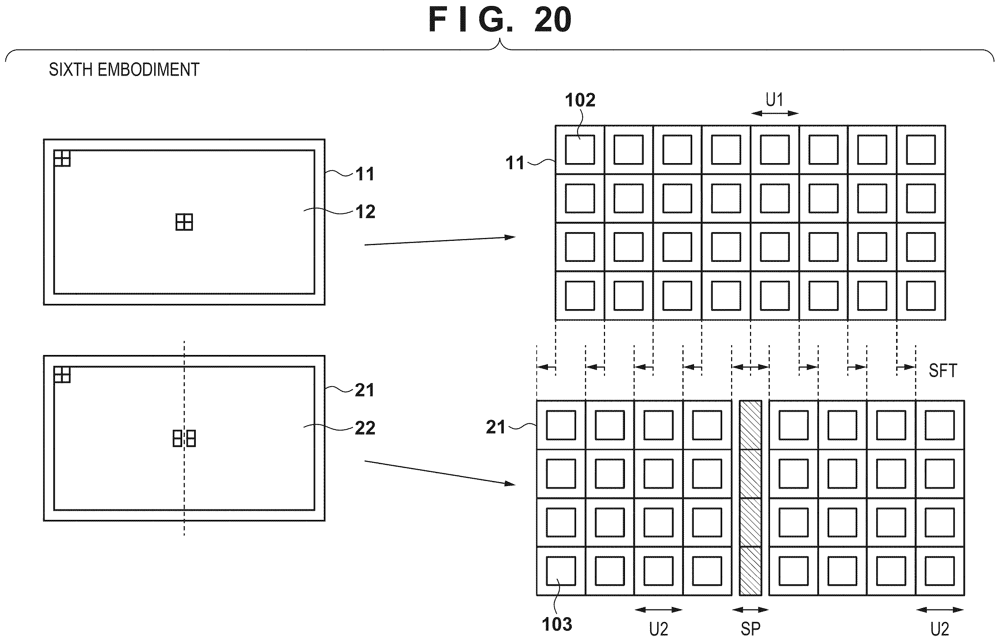

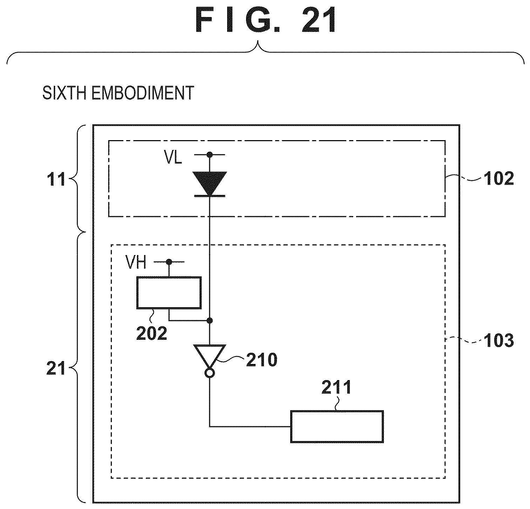

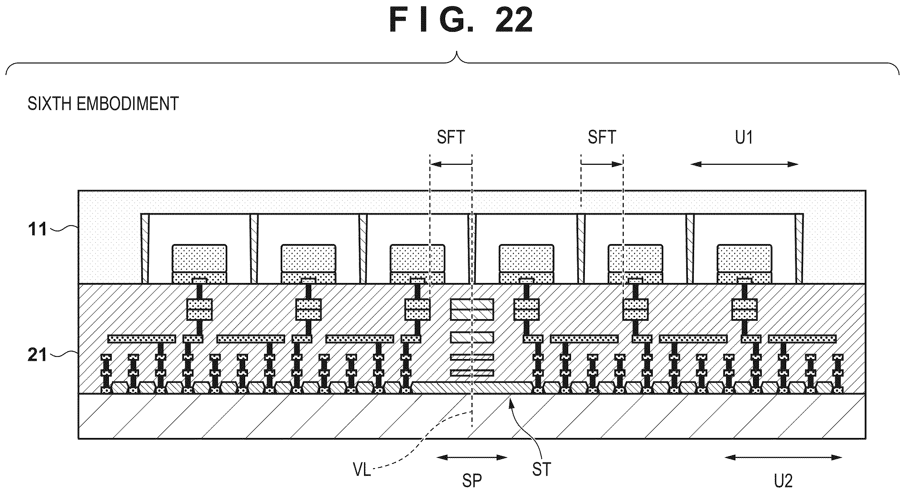

With reference to Figs. 20 to 22, a photoelectric conversion apparatus 100 according to the sixth embodiment will be described. Matters not mentioned regarding the sixth embodiment can follow the description of the first to fourth embodiments. Fig. 20 is a view for explaining a first substrate 11 and a second substrate 21 constituting the photoelectric conversion apparatus 100. Fig. 21 is a view showing the arrangement of a pixel 101. Fig. 22 is a schematic sectional view showing the arrangement of the photoelectric conversion apparatus 100.

In the sixth embodiment, a structure ST that does not constitute a plurality of second unit circuits UC2 can be arranged between a third region R3 and a fourth region R4. In a planar view, the third region R3 and the fourth region R4 may be line-symmetric with respect to a virtual line VL. In the planar view, the structure ST can include a component arranged line-symmetrically with respect to the virtual line VL. The structure ST can be, for example, a metal pattern.

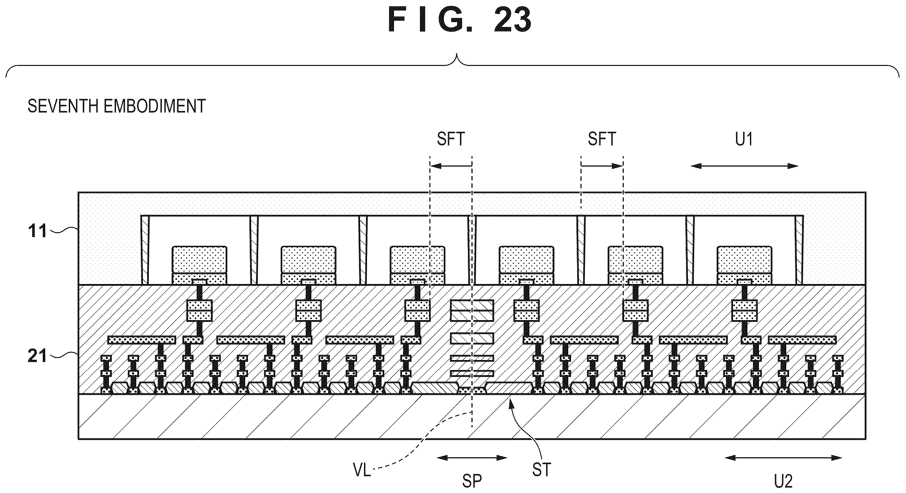

With reference to Fig. 23, a photoelectric conversion apparatus 100 according to the seventh embodiment will be described. Matters not mentioned regarding the seventh embodiment can follow the description of the sixth embodiment. Figs. 20 and 21 are referenced in the seventh embodiment. Fig. 23 is a schematic sectional view showing the arrangement of the photoelectric conversion apparatus 100 according to the seventh embodiment.

In the seventh embodiment, in a planar view, a structure ST can include a component arranged line-symmetrically with respect to a virtual line VL. For example, the component can be arranged to overlap the virtual line VL. The structure ST can include, for example, at least one of a metal pattern, an active region, and a well contact. In an example, the structure ST can include a metal pattern, an active region, and a well contact.

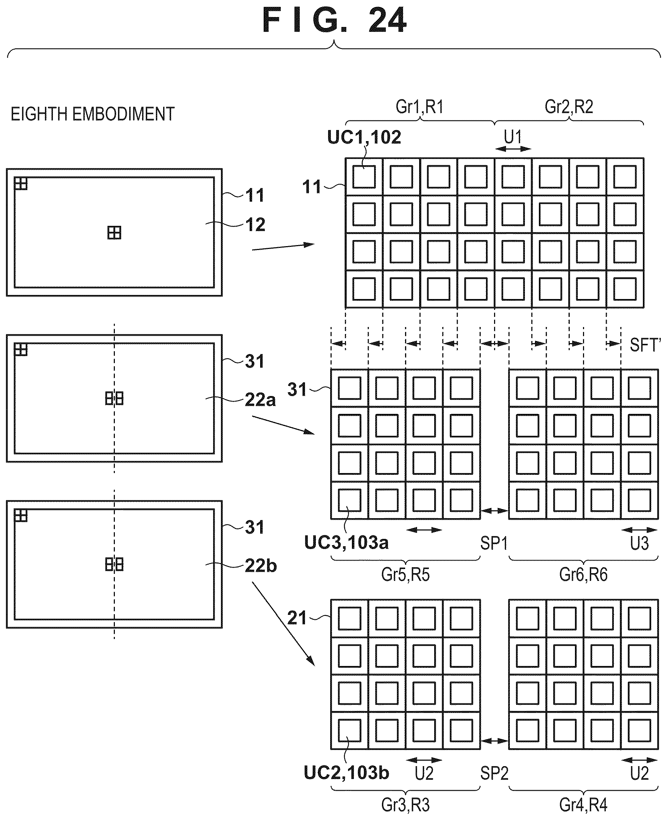

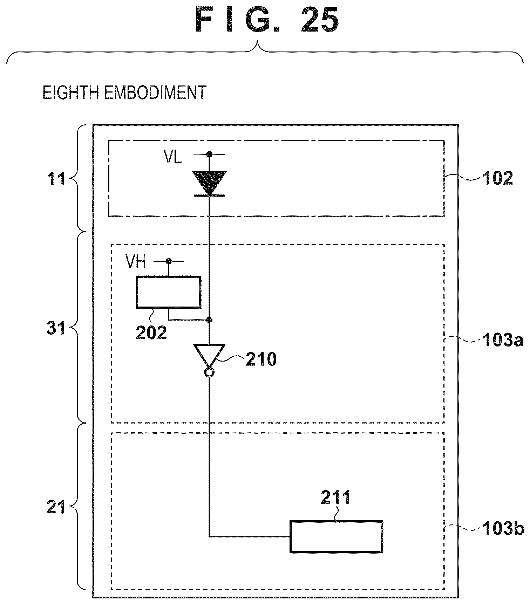

With reference to Figs. 24 and 25, a photoelectric conversion apparatus 100 according to the eighth embodiment will be described. Matters not mentioned regarding the eighth embodiment can follow the description of the first to seventh embodiments. Fig. 24 is a view for explaining a first substrate 11, a second substrate 21, and a third substrate 31 constituting the photoelectric conversion apparatus 100. Fig. 25 is a view showing the arrangement of a pixel 101.

In the eighth embodiment, the first substrate 11 is a substrate formed through a lithography step using one-shot exposure, and each of the second substrate 21 and the third substrate 31 is a substrate formed through a lithography step using divisional exposure. In Fig. 24, a dotted line in the second substrate 21 on the left side schematically indicates that a third region R3 and a fourth region R4 of the second substrate are each subjected to divisional exposure. A dotted line in the third substrate 31 on the left side schematically indicates that a fifth region R5 and a sixth region R6 of the third substrate are each subjected to divisional exposure.

In the eighth embodiment, the photoelectric conversion apparatus 100 includes the third substrate 31 in addition to the first substrate 11 and the second substrate 21. The third substrate 31 is arranged between the first substrate 11 and the second substrate 21. The third substrate 31 can include the fifth region R5 where third unit circuits UC3 of a fifth group Gr5 out of a plurality of third unit circuits UC3 are arranged, and the sixth region R6 where the third unit circuits UC3 of a sixth group Gr6 out of the plurality of third unit circuits UC3 are arranged. The fifth region R5 and the sixth region R6 can be arranged to be shifted from a first region R1 and a second region R2, respectively, so that the fifth region R5 and the sixth region R6 are separated from each other. The fifth region R5 is shifted from the first region R1 by a shift amount SFT', and the sixth region R6 is shifted from the second region R2 by the shift amount SFT'. These shift amounts can be equal to each other. However, the shift amount of the fifth region R5 from the first region R1 and the shift amount of the sixth region R6 from the second region R2 may be different from each other. SFT' may be equal to or different from SFT.

Each of a plurality of first unit circuits UC1 can include an APD 201. Each of a plurality of third unit circuits UC3 can include a quenching element 202 connected to the APD 201 in series, and a waveform shaping circuit 210 that generates a signal obtained by shaping the waveform of a signal output from the APD 201. Each of the plurality of second unit circuits UC2 can include a processing circuit that processes a signal output from the waveform shaping circuit 210.

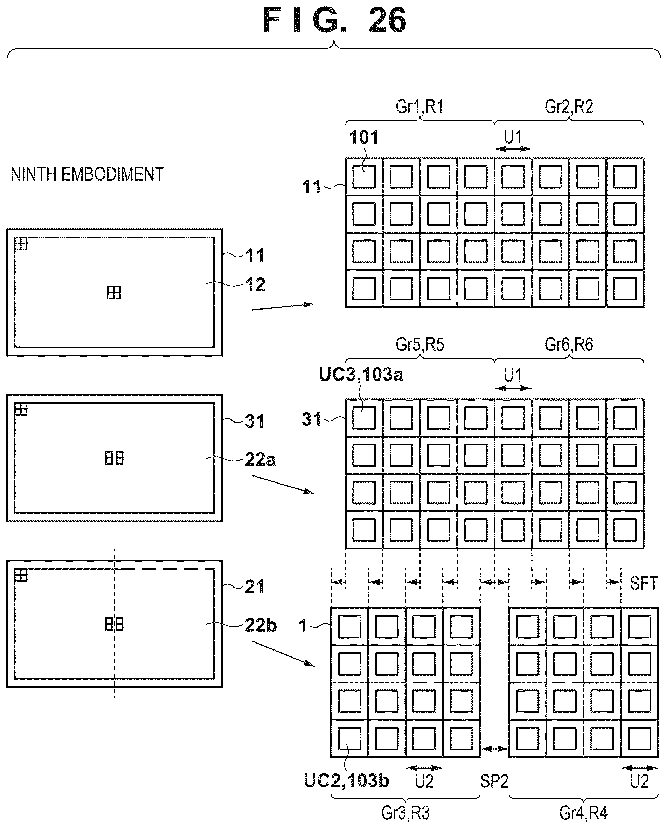

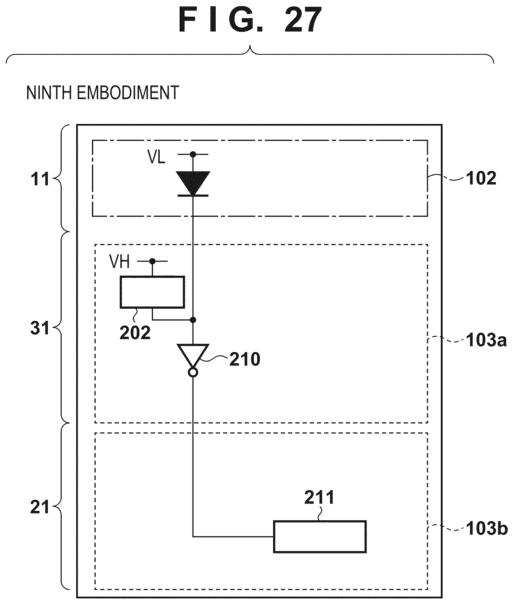

With reference to Figs. 26 and 27, a photoelectric conversion apparatus 100 according to the ninth embodiment will be described. Matters not mentioned regarding the ninth embodiment can follow the description of the first to eighth embodiments. Fig. 26 is a view for explaining a first substrate 11, a second substrate 21, and a third substrate 31 constituting the photoelectric conversion apparatus 100. Fig. 27 is a view showing the arrangement of a pixel 101.

In the ninth embodiment, the photoelectric conversion apparatus 100 includes the third substrate 31 in addition to the first substrate 11 and the second substrate 21. The third substrate 31 is arranged between the first substrate 11 and the second substrate 21. Each of the first substrate 11 and the third substrate 31 is a substrate formed through a lithography step using one-shot exposure, and the second substrate 21 is a substrate formed through a lithography step using divisional exposure. In Fig. 26, a dotted line in the second substrate 21 on the left side schematically indicates that a third region R3 and a fourth region R4 of the second substrate are each subjected to divisional exposure.

The third substrate 31 can include a fifth region R5 where third unit circuits UC3 of a fifth group Gr5 out of a plurality of third unit circuits UC3 are arranged, and a sixth region R6 where the third unit circuits UC3 of a sixth group Gr6 out of the plurality of third unit circuits UC3 are arranged. The third region R3 and the fourth region R4 can be arranged to be shifted from the fifth region R5 and the sixth region R6, respectively, so that the third region R3 and the fourth region R4 are separated from each other.

Each of a plurality of first unit circuits UC1 can include an APD 201. Each of a plurality of third unit circuits UC3 can include a quenching element 202 connected to the APD 201 in series, and a waveform shaping circuit 210 configured to generate a signal obtained by shaping the waveform of a signal output from the APD 201. Each of the plurality of second unit circuits UC2 can include a counter circuit 211 (processing circuit) that processes a signal output from the waveform shaping circuit 210.

In each of the first to ninth embodiments, the example has been described in which the photoelectric conversion element 102 is an APD, but the photoelectric conversion 102 may be a photoelectric conversion element other than the APD.

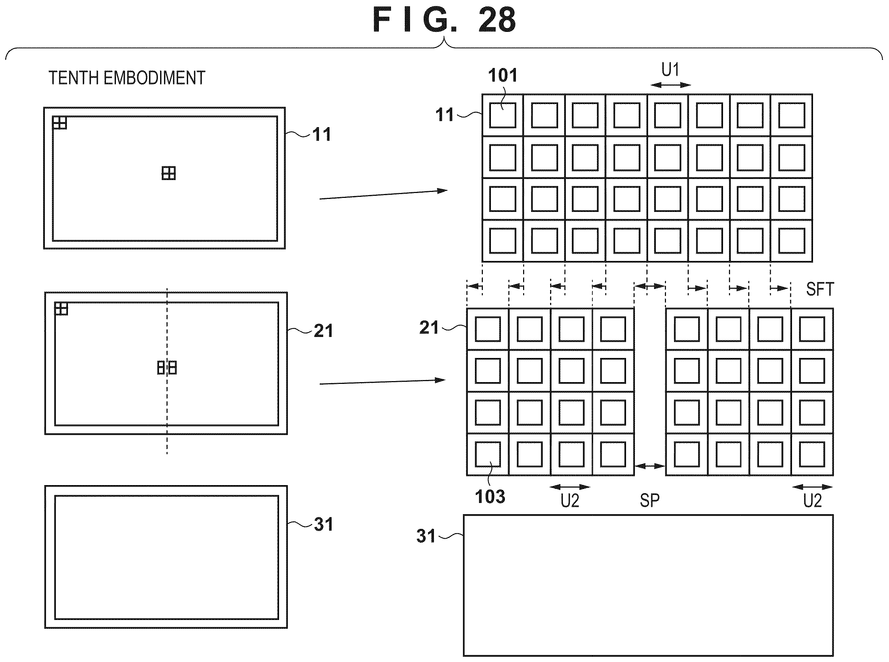

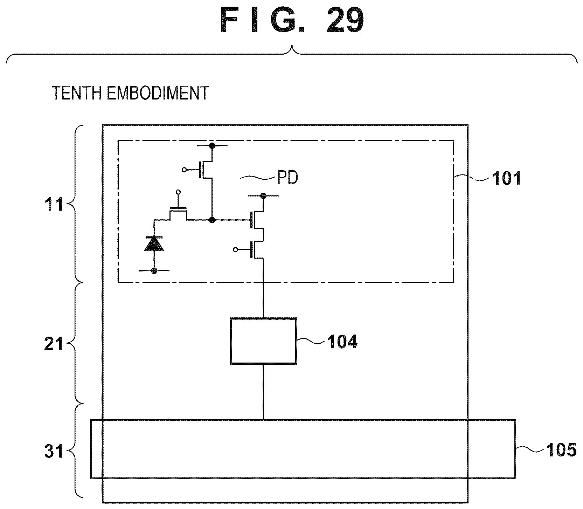

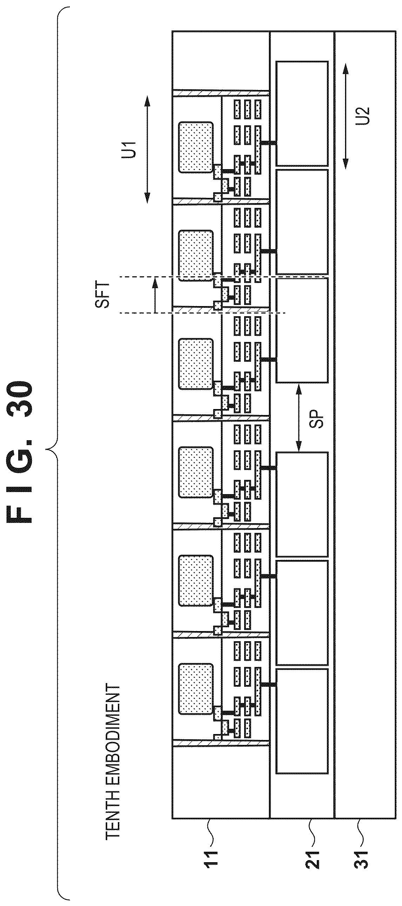

With reference to Figs. 28 to 30, a photoelectric conversion apparatus 100 according to the tenth embodiment will be described. Matters not mentioned regarding the tenth embodiment can follow the description of the first to ninth embodiments. Fig. 28 is a view for explaining a first substrate 11, a second substrate 21, and a third substrate 31 constituting the photoelectric conversion apparatus 100. Fig. 29 is a view showing the arrangement of a pixel 101. Fig. 30 is a schematic sectional view showing the arrangement of the photoelectric conversion apparatus 100.

In the tenth embodiment, the photoelectric conversion apparatus 100 includes the third substrate 31 in addition to the first substrate 11 and the second substrate 21. In the tenth embodiment, the second substrate 21 can be arranged between the first substrate 11 and the third substrate 31. Each of the first substrate 11 and the third substrate 31 is a substrate formed through a lithography step using one-shot exposure, and the second substrate 21 is a substrate formed through a lithography step using divisional exposure. In Fig. 28, a dotted line in the second substrate 21 on the left side schematically indicates that a third region R3 and a fourth region R4 of the second substrate are each subjected to divisional exposure.

In the tenth embodiment, each of a plurality of first unit circuits UC1 can include a photoelectric conversion element PD, and a readout circuit that reads out a signal from the photoelectric conversion element PD. Each of a plurality of second unit circuits UC2 can include a memory 104 that holds a signal read out by the readout circuit of the corresponding first unit circuit UC1 out of the plurality of first unit circuits UC1. The third substrate 31 can include a circuit 105 that processes a signal output from the second substrate 21.

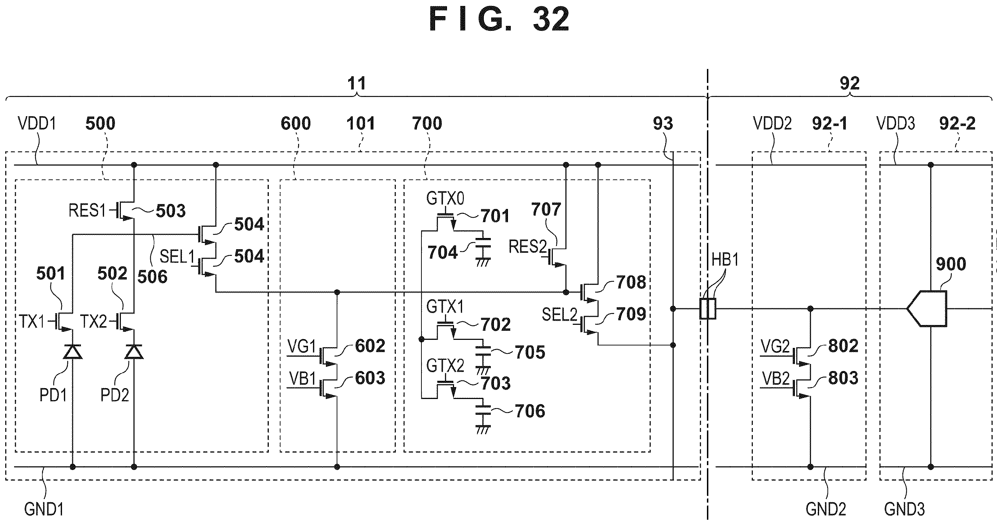

With reference to Fig. 32, a photoelectric conversion apparatus 100 according to the eleventh embodiment will be described. Matters not mentioned regarding the eleventh embodiment can follow the description of the first to tenth embodiments. Fig. 32 exemplarily shows the arrangement of a first substrate 11 and a second substrate 21. In the eleventh embodiment, a second unit circuit UC2 includes a readout circuit 92.

A pixel 101 can include a photoelectric conversion circuit 500, a pixel amplification circuit 600, and a pixel memory circuit 700. The photoelectric conversion circuit 500 can include a first photoelectric conversion element PD1, a second photoelectric conversion element PD2, a first transfer transistor 501, a second transfer transistor 502, and a floating diffusion (floating diffusion region) 506.

Hereinafter, the floating diffusion may be referred to as FD. The photoelectric conversion circuit 500 can include a first reset transistor 503 used to reset the FD 506, a first amplification transistor 504 used to amplify a signal, and a first selection transistor 505. The first photoelectric conversion element PD1 and the second photoelectric conversion element PD2 can be electrically connected to a first reference voltage line GND1 that supplies a reference voltage. The first reset transistor 503 and the first amplification transistor 504 can be electrically connected to a first power supply voltage line VDD1 that supplies a power supply voltage. Note that the number of photoelectric conversion elements included in the photoelectric conversion circuit 500 may be one, or three or more. The first photoelectric conversion element PD1 and the second photoelectric conversion element PD2 are, for example, photodiodes. The first photoelectric conversion element PD1 and the second photoelectric conversion element PD2 are not limited to photodiodes, and may be, for example, photoelectric conversion films.

The first photoelectric conversion element PD1 and the second photoelectric conversion element PD2 receive light entering the pixel 101, generate signal charges corresponding to the incident light, and accumulate the signal charges. The first reset transistor 503 is driven by a control signal RES1. When the first reset transistor 503 is turned on, the FD 506 is reset to a voltage corresponding to the power supply voltage. When the first reset transistor 503 is turned off, the reset of the FD 506 is canceled. The first transfer transistor 501 is driven by a control signal TX1. When the first transfer transistor 501 is turned on, the signal charges generated by the first photoelectric conversion element PD1 are transferred to the FD 506. The FD 506 temporarily holds the signal charges transferred from the first photoelectric conversion element PD1, and functions as a charge-voltage conversion unit that converts the held signal charges into a voltage signal. The first amplification transistor 504 amplifies the pixel signal converted by the FD 506. The first selection transistor 505 is driven by a control signal SEL1, connects the first amplification transistor 504 to the pixel amplification circuit 600, and outputs the pixel signal amplified by the first amplification transistor 504 to the pixel amplification circuit 600. Note that the second photoelectric conversion element PD2 and the second transfer transistor 502 are driven in a similar manner to the first photoelectric conversion element PD1 and the first transfer transistor 501.

The arrangement of the photoelectric conversion circuit 500 shown in Fig. 32 is merely an example, and the photoelectric conversion circuit 500 may further include a transistor. The photoelectric conversion circuit 500 may further be provided with, for example, a transistor that changes the capacitance value of the FD 506, and a transistor that discharges signal charges from the first photoelectric conversion element PD1. Alternatively, the photoelectric conversion circuit 500 may not include the first selection transistor 505. In this case, the selection/non-selection states of the photoelectric conversion circuit 500 can be changed using the voltage supplied from the first reset transistor 503 to the FD 506.

The pixel amplification circuit 600 can include a first cascode transistor 602 and a first transistor 603. Each transistor included in the pixel amplification circuit 600 can be operated in accordance with a control signal supplied by a control unit 95. The first transistor 603 functions as a current source, and supplies a current to the first amplification transistor 504. The first amplification transistor 504, the first cascode transistor 602, and the first transistor 603 function as a source follower circuit (first source follower circuit), and the photoelectric conversion circuit 500 outputs an amplified pixel signal. Note that even if the first cascode transistor 602 is not arranged, the first amplification transistor 504 and the first transistor 603 function as a source follower circuit.

A first bias voltage VG1 can be supplied to the gate electrode of the first cascode transistor 602. A second bias voltage VB1 is supplied to the gate electrode of the first transistor 603. The pixel memory circuit 700 can include an N-signal transistor 701, a first S-signal transistor 702, a second S-signal transistor 703, an N-signal memory circuit 704, a first S-signal memory circuit 705, and a second S-signal memory circuit 706. The pixel memory circuit 700 can further include a second reset transistor 707, a second amplification transistor 708, and a second selection transistor 709. The pixel memory circuit 700 functions as a circuit that holds the pixel signal amplified by the pixel amplification circuit 600. Here, an N signal is a signal at reset level of the photoelectric conversion circuit 500, and an S signal is a photoelectric conversion signal of the photoelectric conversion circuit 500. Each transistor included in the pixel memory circuit 700 can be operated in accordance with a control signal supplied by the control unit 95.

Each of the N-signal memory circuit 704, the first S-signal memory circuit 705, and the second S-signal memory circuit 706 includes a capacitive element (third capacitive element). Note that each transistor included in the pixel 101 may be an n-type MOS transistor or a p-type MOS transistor. Here, an arrangement will be described in which an electron of an electron-hole pair, which is generated by each of the first photoelectric conversion element PD1 and the second photoelectric conversion element PD2 when light enters, is used as the signal charge. When the electron is used as the signal charge, each transistor included in the pixel 101 can be formed as an n-type MOS transistor. However, the signal charge is not limited to the electron, and the hole may be used as the signal charge. When the hole is used as the signal charge, each transistor included in the pixel 101 can be formed as a p-type MOS transistor.

The readout circuit 92 can be constituted by a readout circuit 92-1 and a readout circuit 92-2. The readout circuit 92-1 can include a second cascode transistor 802 and a second transistor 803. The readout circuit 92-2 can include a plurality of AD conversion circuits (analog-digital conversion circuits) 900 corresponding to the respective columns. Each transistor included in the readout circuit 92-1 can be operated in accordance with a control signal supplied from the control unit 95. The second transistor 803 functions as a current source, and supplies a current to the second amplification transistor 708. The second amplification transistor 708, the second cascode transistor 802, and the second transistor 803 function as a source follower circuit (second source follower circuit), and the pixel memory circuit 700 outputs an amplified pixel signal.

A third bias voltage VG2 can be supplied to the gate electrode of the second cascode transistor 802. A fourth bias voltage VB2 can be supplied to the gate electrode of the second transistor 803. Note that even if the second cascode transistor 802 is not arranged, the second amplification transistor 708 and the second transistor 803 function as a source follower circuit.

The pixel signal output from the pixel memory circuit 700 can be output to a signal line 93. The pixel signal can be supplied, via a bonding portion HB1 provided in the first substrate 11 and the second substrate 21, to the plurality of AD conversion circuits (analog-digital conversion circuits) 900 corresponding to the respective columns where a plurality of pixels 101 are arranged.

The first substrate 11 can be electrically connected to the second substrate 21 via the bonding portions HB1 provided in the first substrate 11 and the second substrate 21. The first substrate 11 and the second substrate 21 can be stacked using, for example, hybrid bonding. The bonding portions HB are not limited to using hybrid bonding, and the first substrate 11 may be electrically connected to the second substrate 21 by using conductive vias, bumps, or the like. The signals output from the plurality of AD conversion circuits (analog-digital conversion circuits) 900 can be output to the outside of the sensor via an output unit 94.

The first power supply voltage line VDD1, a second power supply voltage line VDD2, and a third power supply voltage line VDD3 for supplying a power supply voltage can be arranged in the pixel 101 and the readout circuit 92. In addition, the first reference voltage line GND1, a second reference voltage line GND2, and a third reference voltage line GND3 for supplying a reference voltage can be arranged in the pixel 101 and the readout circuit 92. Each of the first power supply voltage line VDD1, the second power supply voltage line VDD2, and the third power supply voltage line VDD3 may be or may not be electrically connected. Each of the first reference voltage line GND1, the second reference voltage line GND2, and the third reference voltage line GND3 may be or may not be electrically connected.

In the second to seventh embodiments described above, the first substrate 11 and the second substrate 21 may have the arrangement shown in Fig. 32. In this case, the second unit circuit UC2 includes the readout circuit 92 instead of the pixel circuit 103.

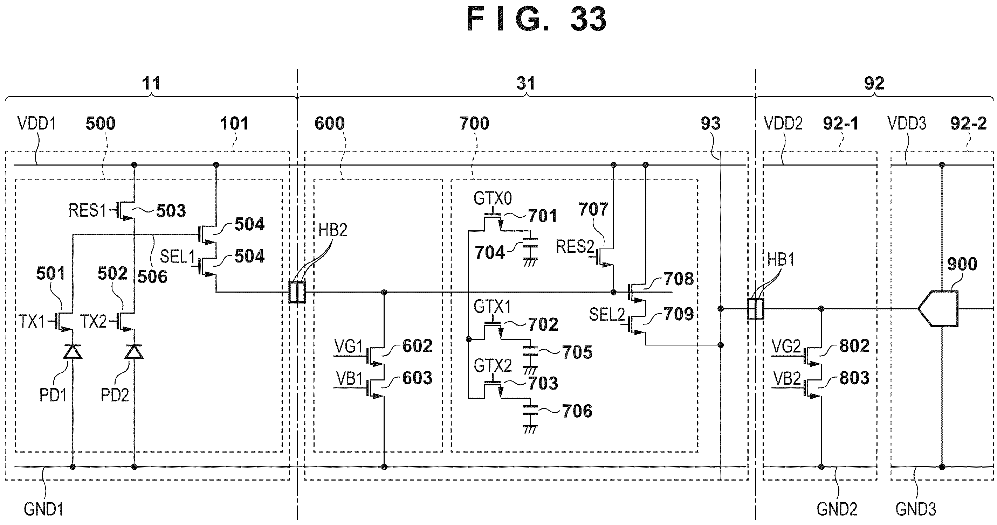

With reference to Fig. 33, a photoelectric conversion apparatus 100 according to the twelfth embodiment will be described. Matters not mentioned regarding the twelfth embodiment can follow the description of the eleventh embodiment. Fig. 33 shows an example of the arrangement of a first substrate 11, a second substrate 21, and a third substrate 31. In the twelfth embodiment, the third substrate 31 includes a pixel amplification circuit 600 and a pixel memory circuit 700. The first substrate 11 and the third substrate 31 can be electrically connected via bonding portions HB2 provided in the first substrate 11 and the third substrate 31. The third substrate 31 and the second substrate 21 can be electrically connected via bonding portions HB1 provided in the third substrate 31 and the second substrate 21. In an example, the first substrate 11 and the third substrate 31 are stacked using hybrid bonding, and the third substrate 31 and the second substrate 21 are also stacked using hybrid bonding. The bonding portions HB are not limited to using hybrid bonding, and may be conductive vias, bumps, or the like.

In the twelfth embodiment, a second unit circuit UC2 includes a readout circuit 92-1 and a readout circuit 92-2, instead of a pixel circuit 103, and the third unit circuit UC3 includes the pixel amplification circuit 600 and the pixel memory circuit 700, instead of a pixel circuit 103.

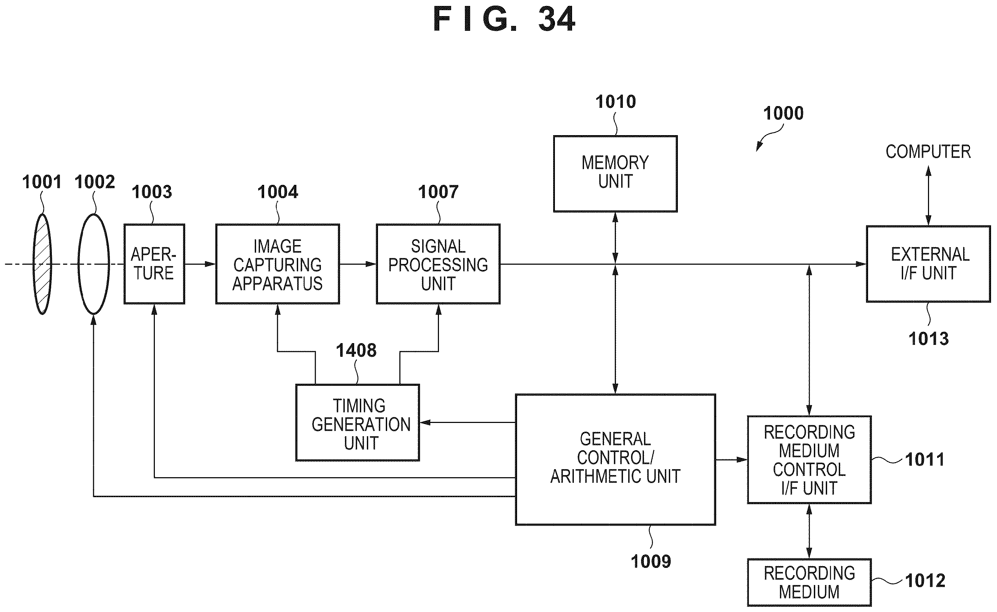

With reference to Fig. 34, a photoelectric conversion system according to the first application example will be described below. Fig. 34 is a block diagram showing the schematic configuration of a photoelectric conversion system according to the first application example.

The above-described photoelectric conversion apparatus 100 is applicable to various kinds of photoelectric conversion systems. Examples of photoelectric conversion systems to which the photoelectric conversion apparatus is applicable are a digital still camera, a digital camcorder, a monitoring camera, a copying machine, a facsimile apparatus, a mobile phone, an in-vehicle camera, and an observation satellite. A camera module including an optical system such as a lens and an image capturing apparatus is also included in the photoelectric conversion systems. Fig. 34 exemplarily shows the block diagram of a digital still camera as an example of these.

A photoelectric conversion system 1000 exemplarily shown in Fig. 34 includes an image capturing apparatus 1004 as an example of the photoelectric conversion apparatus. The photoelectric conversion system 1000 also includes a lens 1002 that forms an optical image of an object on the image capturing apparatus 1004, an aperture 1003 configured to change the amount of light passing through the lens 1002, and a barrier 1001 configured to protect the lens 1002. The lens 1002 and the aperture 1003 form an optical system (optical apparatus) that condenses light to the image capturing apparatus 1004. The image capturing apparatus 1004 is the photoelectric conversion apparatus 100 (image capturing apparatus) according to one of the above-described embodiments, and converts the optical image formed by the lens 1002 into an electrical signal.

The photoelectric conversion system 1000 also includes a signal processing unit 1007 that is an image generation unit configured to generate an image by processing an output signal output from the image capturing apparatus 1004. The signal processing unit 1007 functions as a processing apparatus that performs an operation of performing various kinds of correction and compression as needed, thereby outputting image data. The signal processing unit 1007 may be formed on a semiconductor substrate on which the image capturing apparatus 1004 is provided or may be formed on a semiconductor substrate different from the image capturing apparatus 1004. In addition, the image capturing apparatus 1004 and the signal processing unit 1007 may be formed on the same semiconductor substrate.

The photoelectric conversion system 1000 further includes a memory unit 1010 configured to temporarily store image data, and an external interface unit (external I/F unit) 1013 configured to communicate with an external computer or the like. Furthermore, the photoelectric conversion system 1000 includes a recording medium 1012 such as a semiconductor memory configured to record or read out image capturing data, and a recording medium control I/F unit 1011 configured to record or readout for the recording medium 1012. The recording medium control I/F unit 1011 and the recording medium 1012 can form a part of a recording apparatus. Note that the recording medium 1012 may be incorporated in the photoelectric conversion system 1000 or may be detachable.

Furthermore, the photoelectric conversion system 1000 includes a general control/arithmetic unit 1009 that controls various kinds of operations and the entire digital still camera, and a timing generation unit 1408 that outputs various kinds of timing signals to the image capturing apparatus 1004 and the signal processing unit 1007. The general control/arithmetic unit 1009 and the timing generation unit 1408 can form a part of a control apparatus configured to control an operation of the photoelectric conversion system 1000. In this example, the timing signal and the like may be input from the outside, and the photoelectric conversion system 1000 need only include at least the image capturing apparatus 1004, and the signal processing unit 1007 that processes an output signal output from the image capturing apparatus 1004.

The image capturing apparatus 1004 outputs an image capturing signal to the signal processing unit 1007. The signal processing unit 1007 executes predetermined signal processing for the image capturing signal output from the image capturing apparatus 1004, and outputs image data. The signal processing unit 1007 generates an image using the image capturing signal. Although not shown in Fig. 34, a display apparatus such as a display for displaying the generated image may be arranged in the photoelectric conversion system 1000. As described above, according to this application example, it is possible to implement the photoelectric conversion system 1000 to which the photoelectric conversion apparatus 100 (image capturing apparatus) according to one of the above-described embodiments is applied.

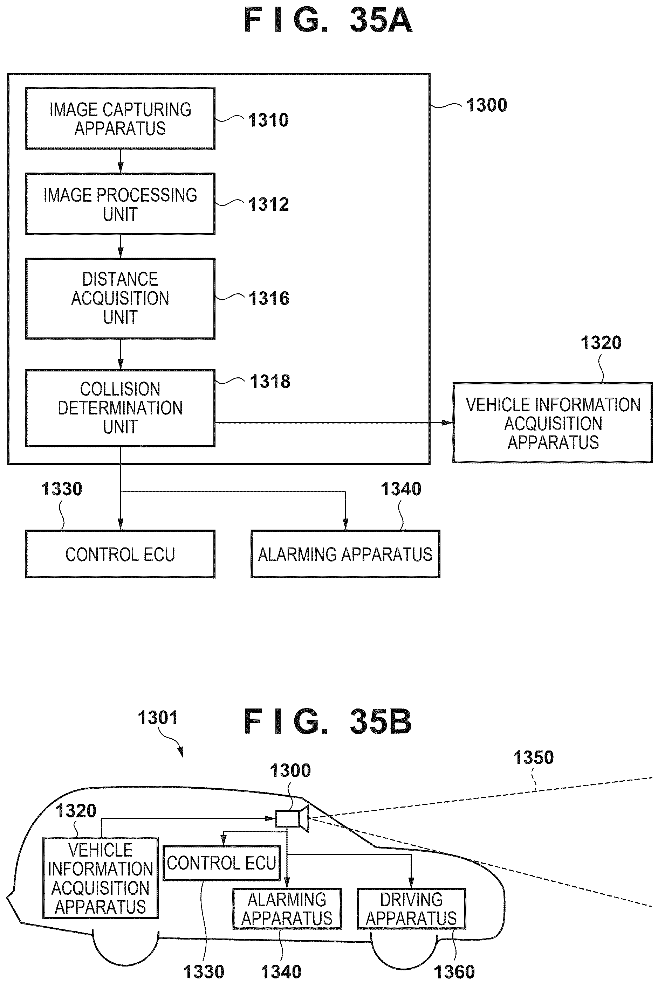

A photoelectric conversion system 1300 and a moving body 1301 according to the second application example will be described with reference to Figs. 35A and 35B. Figs. 35A and 35B are views showing the arrangement of the photoelectric conversion system 1300 and the moving body 1301 according to the second application example.

Fig. 35A shows an example of a photoelectric conversion system concerning an in-vehicle camera. The photoelectric conversion system 1300 includes an image capturing apparatus 1310. The image capturing apparatus 1310 is the photoelectric conversion apparatus 100 (image capturing apparatus) described in one of the above-described embodiments. The photoelectric conversion system 1300 includes an image processing unit 1312 that performs image processing for a plurality of image data acquired by the image capturing apparatus 1310. The photoelectric conversion system 1300 also includes a distance acquisition unit 1316 that calculates the distance up to a target object, and a collision determination unit 1318 that determines, based on the calculated distance, whether there is collision possibility. Here, the distance acquisition unit 1316 may acquire distance information up to a target object by using a Time of Flight (ToF) method, or may acquire distance information by using parallax information or the like. That is, the distance information is information concerning a parallax, a defocus amount, a distance up to a target object, and the like. The collision determination unit 1318 may determine collision possibility using one of the pieces of distance information. The distance acquisition unit 1316 may be implemented by exclusively designed hardware, or may be implemented by a software module. The distance acquisition unit 1316 may be implemented by a Field Programmable Gate Array (FPGA), Application Specific Integrated Circuit (ASIC), or the like. Alternatively, the distance acquisition unit 1316 may be implemented by a combination of these.

The photoelectric conversion system 1300 is connected to a vehicle information acquisition apparatus 1320, and can acquire vehicle information such as a vehicle speed, a yaw rate, and a steering angle. The photoelectric conversion system 1300 is also connected to an ECU 1330 that is a control apparatus configured to output a control signal for generating a braking force to the vehicle based on the determination result of the collision determination unit 1318. Furthermore, the photoelectric conversion system 1300 is connected to an alarm apparatus 1340 that generates an alarm to the driver based on the determination result of the collision determination unit 1318. For example, if collision possibility is high as the determination result of the collision determination unit 1318, the ECU 1330 controls a driving apparatus (machine apparatus) 1360 to perform braking, releasing the accelerator pedal, or suppressing the engine output, thereby controlling the vehicle for avoiding collision and reducing damage. The alarm apparatus 1340 sounds an alarm, displays alarm information on the screen of a car navigation system or the like, or applies a vibration to the seat belt or a steering wheel, thereby issuing an alarm to the user.

In this application example, the periphery of the vehicle (moving body 1301), for example, the front or rear side is captured by the photoelectric conversion system 1300. Fig. 35B shows the photoelectric conversion system when capturing the front side (image capturing range 1350) of the vehicle. The vehicle information acquisition apparatus 1320 sends an instruction to the photoelectric conversion system 1300 or the image capturing apparatus 1310. With this configuration, it is possible to further improve the accuracy of distance measurement.

An example in which control is executed so as not to collide with another vehicle has been explained above. The photoelectric conversion system 1300 can also be applied to control of performing automated driving following another vehicle or control of performing automated driving without deviating from a lane. Furthermore, the photoelectric conversion system 1300 can be applied not only to a vehicle such as an automobile but also to, for example, a moving body (moving apparatus) such as a ship, an airplane, or an industrial robot. The moving body includes one or both of a driving force generation unit that generates a driving force mainly used for moving the moving body and a rotating body mainly used for moving the moving body. The driving force generation unit can be an engine, a motor, or the like. The rotating body can be a tire, a wheel, a ship screw, a propeller of a moving body, or the like. In addition, the photoelectric conversion system can be applied not only to a moving body but also to equipment that broadly uses object recognition, such as an intelligent transport system (ITS).

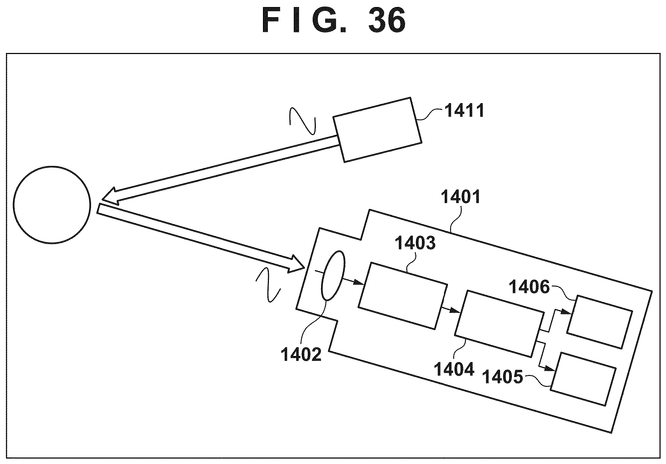

A photoelectric conversion system according to the third application example will be described with reference to Fig. 36. Fig. 36 is a block diagram showing an example of the arrangement of a distance image sensor 1401 as the photoelectric conversion system according to this embodiment.

As shown in Fig. 36, the distance image sensor 1401 includes an optical system 1402, a photoelectric conversion apparatus 1403, an image processing circuit 1404, a monitor 1405, and a memory 1406. Then, the distance image sensor 1401 can receive light (modulated light or pulsed light) projected from a light source apparatus 1411 toward an object and reflected by the surface of the object, thereby acquiring a distance image corresponding to the distance up to the object.

The optical system 1402 is formed by including one or a plurality of lenses, and guides image light (incident light) from the object to the photoelectric conversion apparatus 1403 and forms an image on the light-receiving surface (sensor portion) of the photoelectric conversion apparatus 1403.

As the photoelectric conversion apparatus 1403, the photoelectric conversion apparatus 100 of each of the above-described embodiments is applied, and a distance signal indicating a distance obtained from a light reception signal output from the photoelectric conversion apparatus 1403 is supplied to the image processing circuit 1404.

The image processing circuit 1404 performs image processing of creating a distance image based on the distance signal supplied from the photoelectric conversion apparatus 1403. Then, the distance image (image data) obtained by the image processing is supplied to and displayed on the monitor 1405, and supplied to and stored (recorded) in the memory 1406.

The distance image sensor 1401 having such arrangement can acquire, for example, a more correct distance image along with improvement in characteristic of pixels by applying the above-described photoelectric conversion apparatus 100.

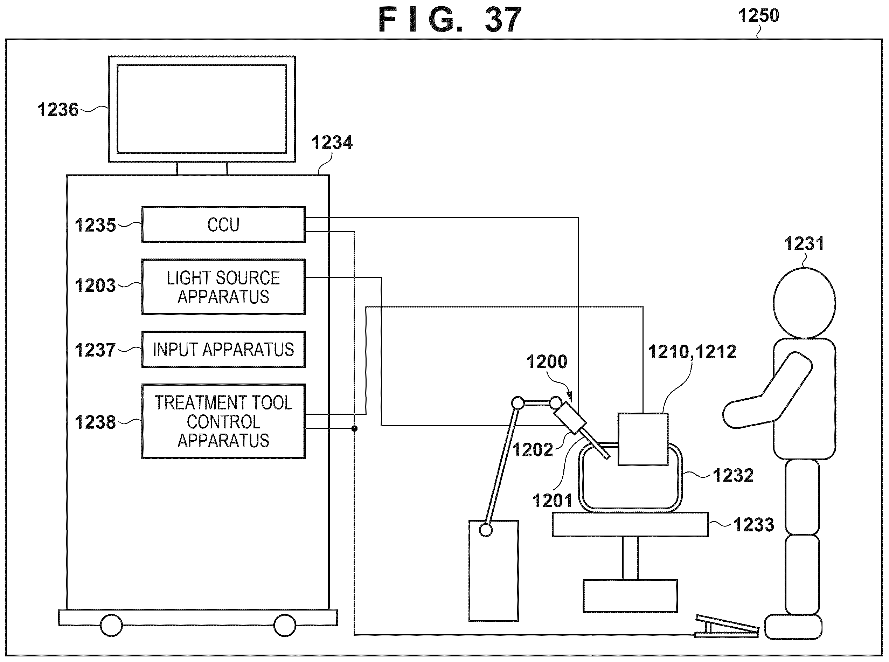

A photoelectric conversion system according to the fourth application example will be described with reference to Fig. 37. Fig. 37 is a view showing an example of the schematic arrangement of an endoscopic surgery system 1250 as the photoelectric conversion system according to the fourth application example.

Fig. 37 shows a state in which an operator (doctor) 1231 operates on a patient 1232 on a patient bed 1233 using the endoscopic surgery system 1250. As shown in Fig. 37, the endoscopic surgery system 1250 is formed from an endoscope 1200, a surgical tool 1210, and a cart 1234 on which various apparatuses for endoscopic surgery are mounted.

The endoscope 1200 includes a lens barrel 1201 including a region of a predetermined length from the distal end, which is inserted into the body cavity of the patient 1232, and a camera head 1202 connected to the proximal end of the lens barrel 1201. In the example shown in Fig. 37, the endoscope 1200 formed as a so-called hard mirror including the hard lens barrel 1201 is shown but the endoscope 1200 may be formed as a so-called soft mirror including a soft lens barrel.

An opening in which an objective lens is fitted is provided at the distal end of the lens barrel 1201. A light source apparatus 1203 is connected to the endoscope 1200, and light generated by the light source apparatus 1203 is guided to the distal end of the lens barrel by a light guide extended inside the lens barrel 1201, and is emitted to an observation target in the body cavity of the patient 1232 via the objective lens. Note that the endoscope 1200 may be a forward-viewing endoscope or may be a forward-oblique viewing endoscope or side-viewing endoscope.

An optical system and a photoelectric conversion apparatus are provided in the camera head 1202, and reflected light (observation light) from the observation target is condensed by the optical system to the photoelectric conversion apparatus. The observation light is photoelectrically converted by the photoelectric conversion apparatus to generate an electrical signal corresponding to the observation light, that is, an image signal corresponding to an observation image. As the photoelectric conversion apparatus, the photoelectric conversion apparatus 100 (image capturing apparatus) described in each of the above-described embodiments can be used. The image signal is transmitted as RAW data to a Camera Control Unit (CCU) 1235.

The CCU 1235 is formed by a Central Processing Unit (CPU), a Graphics Processing Unit (GPU), and the like, and comprehensively controls the operations of the endoscope 1200 and a display apparatus 1236. Furthermore, the CCU 1235 receives an image signal from the camera head 1202, and performs, for the image signal, various kinds of image processes such as development processing (demosaic processing) for displaying an image based on the image signal.

Under the control of the CCU 1235, the display apparatus 1236 displays the image based on the image signal having undergone the image processing by the CCU 1235.

The light source apparatus 1203 is formed from a light source such as a Light Emitting Diode (LED), and supplies, to the endoscope 1200, irradiation light at the time of imaging a surgical site or the like.

An input apparatus 1237 is an input interface to the endoscopic surgery system 1250. The user can input various kinds of information or instructions to the endoscopic surgery system 1250 via the input apparatus 1237.

A treatment tool control apparatus 1238 controls driving of an energy treatment tool 1212 for ablation or incision of the tissue, sealing of a blood vessel, or the like.

The light source apparatus 1203 that supplies, to the endoscope 1200, irradiation light at the time of imaging a surgical site can be formed from, for example, a white light source formed by an LED, a laser light source, or a combination thereof. If the white light source is formed by a combination of RGB laser light sources, it is possible to accurately control the output intensity and output timing of each color (each wavelength), and thus the light source apparatus 1203 can adjust the white balance of a captured image. In this case, the observation target is time-divisionally irradiated with laser beams from the RGB laser light sources, respectively, and driving of the image sensor of the camera head 1202 is controlled in synchronism with the irradiation timings, thereby making it possible to time-divisionally capture images respectively corresponding to R, G, and B. In this method, it is possible to obtain a color image without providing color filters in the image sensor.

Driving of the light source apparatus 1203 may be controlled to change the intensity of light to be output at predetermined intervals. It is possible to time-divisionally acquire images by controlling driving of the image sensor of the camera head 1202 in synchronism with the timing of changing the intensity of the light, and combine the images, thereby generating an image of a high dynamic range without so-called shadow detail loss or highlight detail loss.

The light source apparatus 1203 may be configured to supply light in a predetermined wavelength band corresponding to special light observation. In special light observation, for example, the wavelength dependency of light absorption in the body tissue is used. More specifically, by performing irradiation with light in a narrow band, as compared with irradiation light (that is, white light) at the time of normal observation, predetermined tissue such as a blood vessel in the mucous membrane surface layer is captured with high contrast. Alternatively, in special light observation, fluorescence observation for obtaining an image by using fluorescence generated by performing radiation with excitation light may be performed. In fluorescence observation, it is possible to, for example, irradiate body tissue with excitation light and observe fluorescence from the body tissue, or locally inject a reagent such as indocyanine green (ICG) to body tissue while irradiating the body tissue with excitation light corresponding to the fluorescence wavelength of the reagent, thereby obtaining a fluorescence image. The light source apparatus 1203 can be configured to supply narrow band light and/or excitation light corresponding to such special light observation.

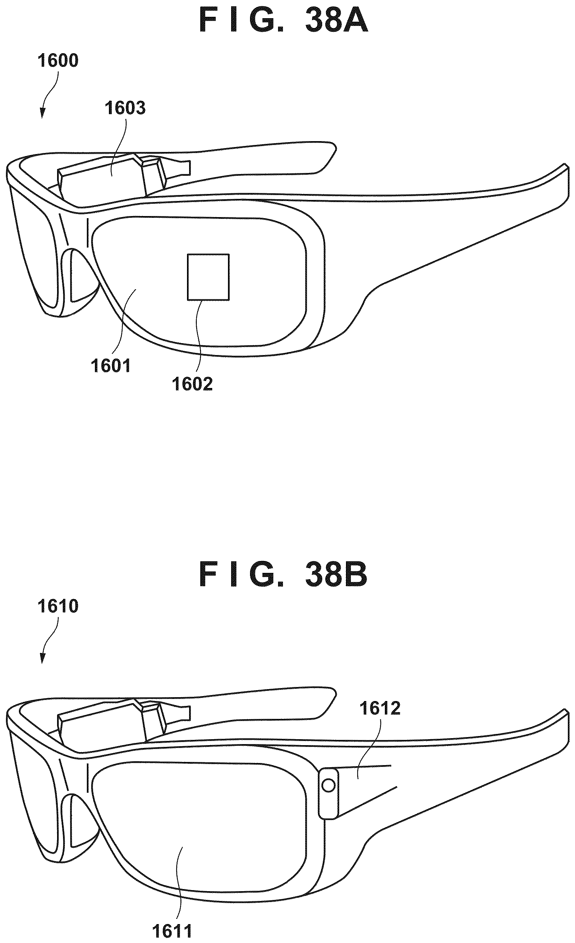

A photoelectric conversion system according to the fifth application example will be described with reference to Figs. 38A and 38B. Fig. 38A describes glasses 1600 (smartglasses) as the photoelectric conversion system according to the fifth application example. The glasses 1600 include a photoelectric conversion apparatus 1602. The photoelectric conversion apparatus 1602 is the photoelectric conversion apparatus 100 (image capturing apparatus) described in each of the above embodiments. A display apparatus including the light emitting apparatus such as an OLED or LED may be provided on the back surface side of a lens 1601. One or a plurality of photoelectric conversion apparatuses 1602 may be provided. Alternatively, a plurality of kinds of photoelectric conversion apparatuses may be used in combination. The arrangement position of the photoelectric conversion apparatus 1602 is not limited to that shown in Fig. 38A.

The glasses 1600 further include a control apparatus 1603. The control apparatus 1603 functions as a power supply that supplies electric power to the photoelectric conversion apparatus 1602 and the above-described display apparatus. In addition, the control apparatus 1603 controls the operations of the photoelectric conversion apparatus 1602 and the display apparatus. An optical system configured to condense light to the photoelectric conversion apparatus 1602 is formed on the lens 1601.

Fig. 38B describes glasses 1610 (smartglasses) according to an application example. The glasses 1610 include a control apparatus 1612, and a photoelectric conversion apparatus corresponding to the photoelectric conversion apparatus 1602 and a display apparatus are mounted on the control apparatus 1612. The photoelectric conversion apparatus in the control apparatus 1612 and an optical system configured to project light emitted from the display apparatus are formed in a lens 1611, and an image is projected to the lens 1611. The control apparatus 1612 functions as a power supply that supplies electric power to the photoelectric conversion apparatus and the display apparatus, and controls the operations of the photoelectric conversion apparatus and the display apparatus. The control apparatus may include a line-of-sight detection unit that detects the line of sight of a wearer. The detection of a line of sight may be done using infrared rays. An infrared ray emitting unit emits infrared rays to an eyeball of the user who is gazing at a displayed image. An image capturing unit including a light receiving element detects reflected light of the emitted infrared rays from the eyeball, thereby obtaining a captured image of the eyeball. A reduction unit for reducing light from the infrared ray emitting unit to the display unit in a plan view is provided, thereby reducing deterioration of image quality.

The line of sight of the user to the displayed image is detected from the captured image of the eyeball obtained by capturing the infrared rays. An arbitrary known method can be applied to the line-of-sight detection using the captured image of the eyeball. As an example, a line-of-sight detection method based on a Purkinje image obtained by reflection of irradiation light by a cornea can be used.

More specifically, line-of-sight detection processing based on pupil center corneal reflection is performed. Using pupil center corneal reflection, a line-of-sight vector representing the direction (rotation angle) of the eyeball is calculated based on the image of the pupil and the Purkinje image included in the captured image of the eyeball, thereby detecting the line-of-sight of the user.

The display apparatus according to this application example can include a photoelectric conversion apparatus including a light receiving element, and control a displayed image of the display apparatus based on the line-of-sight information of the user from the photoelectric conversion apparatus.

More specifically, the display apparatus decides a first visual field region at which the user is gazing and a second visual field region other than the first visual field region based on the line-of-sight information. The first visual field region and the second visual field region may be decided by the control apparatus of the display apparatus, or those decided by an external control apparatus may be received. In the display region of the display apparatus, the display resolution of the first visual field region may be controlled to be higher than the display resolution of the second visual field region. That is, the resolution of the second visual field region may be lower than that of the first visual field region.

In addition, the display region includes a first display region and a second display region different from the first display region, and a region of higher priority may be decided from the first display region and the second display region based on line-of-sight information. The first visual field region and the second visual field region may be decided by the control apparatus of the display apparatus, or those decided by an external control apparatus may be received. The resolution of the region of higher priority may be controlled to be higher than the resolution of the region other than the region of higher priority. That is, the resolution of the region of relatively low priority may be low.

Note that Al may be used to decide the first visual field region or the region of higher priority. The Al may be a model configured to estimate the angle of the line of sight and the distance to a target object ahead of the line of sight from the image of the eyeball using the image of the eyeball and the direction of actual viewing of the eyeball in the image as supervised data. The Al program may be held by the display apparatus, the photoelectric conversion apparatus, or an external apparatus. If the external apparatus holds the Al program, it is transmitted to the display apparatus via communication.

When performing display control based on line-of-sight detection, smartglasses further including a photoelectric conversion apparatus configured to capture the image of the outside can preferably be applied. The smartglasses can display the captured outside image information in real time.

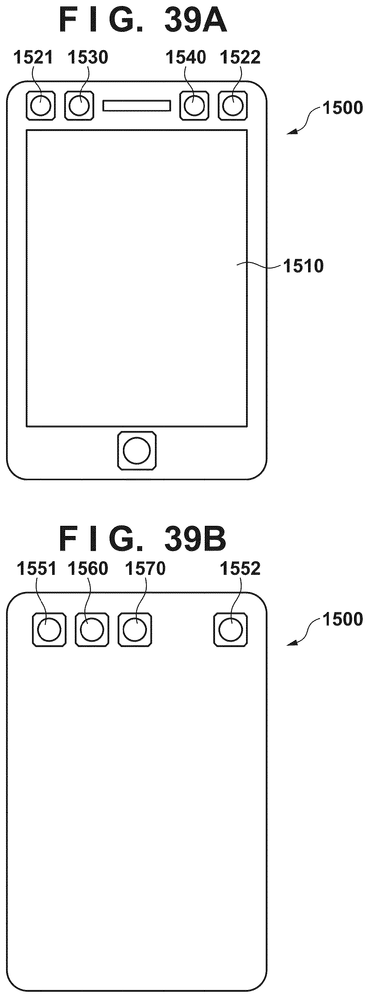

The sixth application example will be described with reference to Figs. 39A and 39B. The above-described photoelectric conversion apparatus and photoelectric conversion system may be applied to, for example, electronic equipment such as a so-called smartphone or tablet.

Figs. 39A and 39B are views showing an example of electronic equipment 1500 on which the photoelectric conversion apparatus is mounted. Fig. 39A shows the front surface side of the electronic equipment 1500, and Fig. 39B shows the back surface side of the electronic equipment 1500.

As shown in Fig. 39A, a display 1510 that displays an image is arranged at the center of the front surface of the electronic equipment 1500. Then, front cameras 1521 and 1522 for each of which the above-described photoelectric conversion apparatus 100 is used, an IR light source 1530 that emits infrared rays, and a visible light source 1540 that emits visible light are arranged along the upper side of the front surface of the electronic equipment 1500.

As shown in Fig. 39B, rear cameras 1551 and 1552 for each of which the above-described photoelectric conversion apparatus 100 is used, an IR light source 1560 that emits infrared rays, and a visible light source 1570 that emits visible light are arranged along the upper side of the back surface of the electronic equipment 1500.

By applying the above-described photoelectric conversion apparatus 100, the electronic equipment 1500 having the above arrangement can capture, for example, an image of higher quality. Note that the photoelectric conversion apparatus can be applied to electronic equipment such as an infrared sensor, a distance measurement sensor using an active infrared source, a security camera, or a personal or biometric authentication camera. This can improve the accuracy and performance of the electronic equipment.

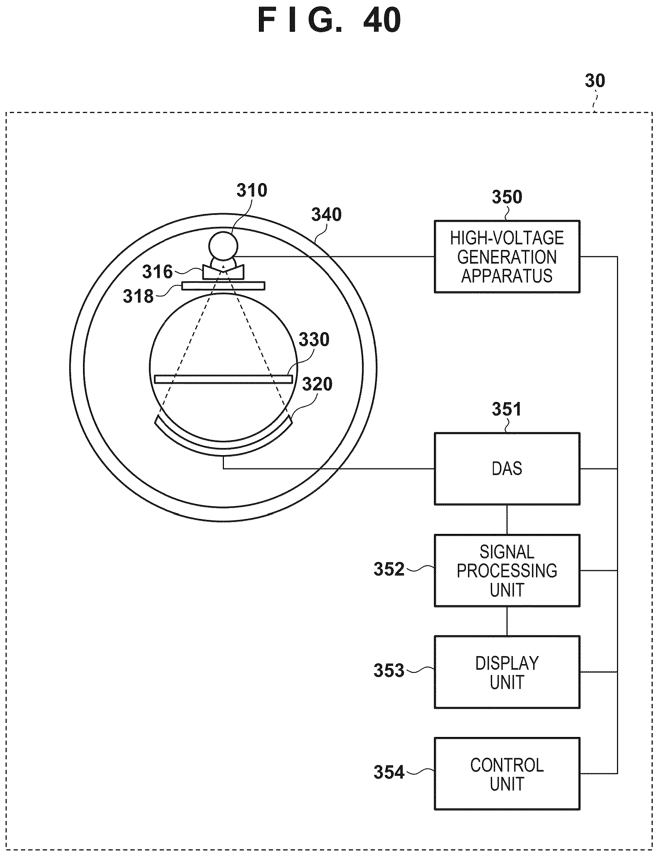

Fig. 40 is a block diagram of an X-ray CT apparatus according to the seventh application example. The above-described photoelectric conversion apparatus 100 is applicable to a detector of the X-ray CT apparatus. An X-ray CT apparatus 30 according to this application example includes an X-ray generation unit 310, a wedge 316, a collimator 318, an X-ray detection unit 320, a top plate 330, a rotating frame 340, and a high-voltage generation apparatus 350. The X-ray CT apparatus 30 also includes a Data Acquisition System (DAS) 351, a signal processing unit 352, a display unit 353, and a control unit 354.

The X-ray generation unit 310 is formed from, for example, a vacuum tube that generates X-rays. The vacuum tube of the X-ray generation unit 310 is supplied with a filament current and a high voltage from the high-voltage generation apparatus 350. When thermoelectrons are emitted from a cathode (filament) to an anode (target), X-rays are generated.

The wedge 316 is a filter that adjusts the amount of X-rays emitted from the X-ray generation unit 310. The wedge 316 attenuates the amount of X-rays so that the X-rays emitted from the X-ray generation unit 310 to an object have a predetermined distribution. The collimator 318 is formed from a lead plate that narrows the irradiation range of the X-rays having passed through the wedge 316. The X-rays generated by the X-ray generation unit 310 are formed in a cone beam shape via the collimator 318, and the object on the top plate 330 is irradiated with the X-rays.

The X-ray detection unit 320 is formed using the above-described photoelectric conversion apparatus 100. The X-ray detection unit 320 detects the X-rays having passed through the object from the X-ray generation unit 310, and outputs a signal corresponding to the amount of the X-rays to the DAS 351.

The rotating frame 340 is annular, and is configured to be rotatable. The X-ray generation unit 310 (the wedge 316 and the collimator 318) and the X-ray detection unit 320 are arranged to face each other in the rotating frame 340. The X-ray generation unit 310 and the X-ray detection unit 320 can rotate together with the rotating frame 340.

The high-voltage generation apparatus 350 includes a boosting circuit, and outputs a high voltage to the X-ray generation unit 310. The DAS 351 includes an amplification circuit and an A/D conversion circuit, and outputs, as digital data, a signal from the X-ray detection unit 320 to the signal processing unit 352.

The signal processing unit 352 includes a Central Processing Unit (CPU), a Read Only Memory (ROM), and a Random Access Memory (RAM), and can execute image processing and the like for the digital data. The display unit 353 includes a flat display apparatus or the like, and can display an X-ray image. The control unit 354 includes a CPU, a ROM, a RAM, and the like, and controls the operation of the overall X-ray CT apparatus 30.

Various embodiments have been described in detail above but it will be understood that the present disclosure is not limited to these embodiments and encompasses all modifications, variants, alternatives and equivalents falling within the scope of the appended claims.

## Claims

1. A photoelectric conversion apparatus comprising a first substrate and a second substrate, wherein
the first substrate includes a plurality of first unit circuits, and each first unit circuit includes at least one photoelectric conversion element,
the second substrate includes a plurality of second unit circuits configured to process signals output from the first substrate,
the first substrate is stacked on the second substrate,
the first substrate includes a first region where first unit circuits of a first group out of the plurality of first unit circuits are arranged, and a second region where first unit circuits of a second group out of the plurality of first unit circuits are arranged,
the second substrate includes a third region where second unit circuits of a third group out of the plurality of second unit circuits are arranged, and a fourth region where second unit circuits of a fourth group out of the plurality of second unit circuits are arranged,
the third region and the fourth region are arranged to be shifted from the first region and the second region, respectively, so that the third region and the fourth region are separated from each other, and
a distance between the third region and the fourth region is smaller than an array pitch of the plurality of first unit circuits in the first substrate.

2. The apparatus according to claim 1, wherein
a distance between the third region and the fourth region is larger than a maximum space width in the second unit circuit arranged in the third region, and a maximum space width in the second unit circuit arranged in the fourth region.

3. The apparatus according to claim 1, wherein
in a direction separating the third region and the fourth region, the array pitch of the first unit circuit in the first substrate is equal to an array pitch of the second unit circuit of the third group in the second substrate and an array pitch of the second unit circuit of the fourth group in the second substrate.

4. The apparatus according to claim 1, wherein
in a direction separating the third region and the fourth region, an array pitch of the second unit circuit of the third group in the second substrate and an array pitch of the second unit circuit of the fourth group in the second substrate are equal to each other.

5. The apparatus according to claim 1, wherein
in a direction separating the third region and the fourth region, an array pitch of the second unit circuit of the third group in the second substrate and an array pitch of the second unit circuit of the fourth group in the second substrate are larger than an array pitch of the first unit circuit in the first substrate.

6. The apparatus according to claim 1, wherein
in a direction separating the third region and the fourth region, an array pitch of the second unit circuit of the third group in the second substrate and an array pitch of the second unit circuit of the fourth group in the second substrate are smaller than an array pitch of the first unit circuit in the first substrate, and
a distance between the third region and the fourth region is smaller than an array pitch of the second unit circuit of the third group in the second substrate.

7. The apparatus according to claim 6, wherein
in a direction separating the third region and the fourth region, an array pitch of the second unit circuit of the third group in the second substrate and an array pitch of the second unit circuit of the fourth group in the second substrate are equal to each other.

8. The apparatus according to claim 1, wherein
in a planar view, the first region and the second region are line-symmetric with respect to a virtual line, and the third region and the fourth region are line-symmetric with respect to the virtual line.

9. The apparatus according to claim 1, wherein
a structure that does not constitute the plurality of second unit circuits is arranged between the third region and the fourth region.

10. The apparatus according to claim 9, wherein
the structure includes at least one of a metal pattern, an active region, and a well contact.

11. The apparatus according to claim 1, wherein
each of the plurality of first unit circuits includes an avalanche photodiode,
each of the plurality of second unit circuits includes a quench element connected to the avalanche photodiode in series, and a waveform shaping circuit configured to generate a signal obtained by shaping a waveform of a signal output from the avalanche photodiode, and
the second substrate includes a processing circuit configured to process a signal output from the waveform shaping circuit.

12. The apparatus according to claim 1, wherein
each of the plurality of first unit circuits includes a photoelectric conversion element configured to generate a charge corresponding to incident light, a floating diffusion configured to output a signal corresponding to the charge, a first source follower circuit configured to amplify a signal output from the floating diffusion, a first transistor configured to drive the first source follower circuit, and a second source follower circuit configured to amplify a signal output from the first source follower circuit,
each of the plurality of second unit circuits includes a second transistor configured to drive the second source follower circuit, and
the second substrate includes a signal processing circuit configured to process a signal output from the second source follower circuit.

13. The apparatus according to claim 1, further comprising a third substrate that includes a plurality of third unit circuits configured to process signals output from the second substrate,
wherein
the third substrate includes a fifth region where third unit circuits of a fifth group out of the plurality of third unit circuits are arranged, and a sixth region where third unit circuits of a sixth group out of the plurality of third unit circuits are arranged, and
the fifth region and the sixth region are arranged to be shifted from the first region and the second region, respectively, so that the fifth region and the sixth region are separated from each other.

14. The apparatus according to claim 13, wherein
each of the plurality of first unit circuits includes a photoelectric conversion element configured to generate a charge corresponding to incident light, a floating diffusion configured to output a signal corresponding to the charge, and a first source follower circuit configured to amplify a signal output from the floating diffusion,
each of the plurality of second unit circuits includes a first transistor configured to drive the first source follower circuit, and a second source follower circuit configured to amplify a signal output from the first source follower circuit,
each of the plurality of third unit circuits includes a second transistor configured to drive the second source follower circuit, and
the third substrate includes a signal processing circuit configured to process a signal output from the second source follower circuit.

15. The apparatus according to claim 1, further comprising a third substrate that includes a plurality of third unit circuits configured to process signals output from the second substrate,
wherein
the third substrate includes a fifth region where third unit circuits of a fifth group out of the plurality of third unit circuits are arranged, and a sixth region where third unit circuits of a sixth group out of the plurality of third unit circuits are arranged, and
the third region and the fourth region are arranged to be shifted from the fifth region and the sixth region, respectively.

16. The apparatus according to claim 15, wherein
each of the plurality of first unit circuits includes a photoelectric conversion element configured to generate a charge corresponding to incident light, a floating diffusion configured to output a signal corresponding to the charge, and a first source follower circuit configured to amplify a signal output from the floating diffusion,
each of the plurality of second unit circuits includes a first transistor configured to drive the first source follower circuit, and a second source follower circuit configured to amplify a signal output from the first source follower circuit,
each of the plurality of third unit circuits includes a second transistor configured to drive the second source follower circuit, and
the third substrate includes a signal processing circuit configured to process a signal output from the second source follower circuit.

17. The apparatus according to any one of claims 1 to 16, wherein
each of the plurality of first unit circuits includes a readout circuit configured to read out a signal from the at least one photoelectric conversion element, and
each of the plurality of second unit circuits includes a memory configured to hold a signal read out by the readout circuit of a corresponding first unit circuit out of the plurality of first unit circuits.

18. A photoelectric conversion system comprising:
a photoelectric conversion apparatus defined in any one of claims 1 to 17; and
a signal processing unit configured to process a signal output from the photoelectric conversion apparatus.
